# FASCICULE DE BREVET EUROPEEN

(11) **EP 2 541 222 B1**
(45) Date de publication et mention de la délivrance du brevet: **21.02.2018**
(21) Numéro de dépôt: 12174451.0
(22) Date de dépôt: 29.06.2012
(51) Int. Cl.: G01L 9/00

(54) **Dispositif de mesure de pression a sensibilite optimisee**
Druckmessgerät mit optimierter Emfpindlichkeit
Pressure-measurement device with optimised sensitivity

(30) Priorité: 01.07.2011 FR 1155954
(43) Date de publication de la demande: 02.01.2013
(73) Titulaire: Commissariat à l'Énergie Atomique et aux Énergies Alternatives, 75015 Paris (FR)
(72) Inventeur: Robert, Philippe, 38000 Grenoble (FR); Jourdan, Guillaume, 38000 Grenoble (FR)
(74) Mandataire: Ilgart, Jean-Christophe

(56) Documents cités:
- EP-A1- 0 143 738
- US-A- 5 824 910
- US-A1- 2004 168 519

## Description

### DOMAINE TECHNIQUE ET ART ANTÉRIEUR

La présente invention se rapporte à des capteurs de pression présentant une sensibilité optimisée, les capteurs sont du type MEMS (Microelectromechanical Systems) ou systèmes microélectromécaniques et/ou NEMS (Nanoelectromechanical Systems) ou systèmes nanoélectromécaniques.

Un capteur de pression est classiquement constitué d'une membrane encastrée apte à se déformer sous une différence de pression qui s'exerce entre ses deux faces. Dans le cas d'un capteur de pression absolue, la membrane sépare un volume de référence sous vide du milieu extérieur à mesurer. La membrane se déforme alors plus où moins en fonction de la pression extérieure.

La déformation de la membrane peut être détectée et mesurée par différentes techniques.

L'une d'elles est de type capacitif. La déflexion de la membrane est déterminée en mesurant la variation de capacité du condensateur formé entre la membrane et une contre-électrode fixe en regard. La membrane est réalisée sur un premier substrat et la contre-électrode est formée sur un deuxième substrat, les deux substrats sont ensuite scellés sous vide. La distance d'entrefer du condensateur est donc déterminée par l'entrefer de scellement, qu'il est difficile de maîtriser parfaitement.

Une autre technique de détection met en oeuvre des jauges piézorésistives, les jauges sont alors disposées directement sur la membrane, celles-ci sont donc déformées directement par la déformation de la membrane.

Une autre technique de détection met en oeuvre un résonateur, par exemple de type poutre suspendue ou diapason. Cette technique consiste à mesurer une variation de la fréquence de résonance du résonateur. La déflexion de la membrane sous l'effet de la pression génère une contrainte sur un résonateur fixé directement sur la membrane, qui a pour effet de modifier sa fréquence de résonance. La mesure du décalage en fréquence permet par conséquent de remonter à la pression.

Les capteurs de pression quelle que soit la technique de détection utilisée n'offre pas une sensibilité optimisée. En outre, ils ne permettent pas de réaliser facilement de détection différentielle.

De plus d'un point de vue procédé de réalisation, la technologie mise en oeuvre pour réaliser les capteurs de pression MEMS est en générale très éloignée de celle utilisée pour la fabrication des capteurs inertiels en technologie de surface. Il en résulte donc qu'il y a peu de co-intégration possible de ces deux types de capteurs.

Le document EP 0 143 738 décrit un capteur de pression comportant une membrane suspendue munie d'une surépaisseur sur laquelle sont formées des jauges de mesure, ces dernières n'étant alors par ancrées entre deux pièces mobiles indépendantes. La surépaisseur se déforme en flexion avec la membrane, ce qui déforme les jauges. Les jauges sont disposées sur l'axe de rotation. Ce capteur n'offre pas de sensibilité optimisée.

Le document US 2004/0168519 décrit un capteur de pression comportant une jauge de contrainte en forme de H disposée sous une membrane et fixée à un bord d'une cavité. La jauge se déforme lorsque la membrane est déformée par l'application d'une pression sur celle-ci, sans effet d'amplification de la contrainte par l'intermédiaire d'un bras de levierformé de moyens de transmission indéformables. Le document US5824910 décrit un autre commutateur de pression de l'art antérieur.

### EXPOSÉ DE L'INVENTION

C'est par conséquent un but de la présente invention d'offrir un dispositif de mesure de pression type MEMS et/ou NEMS offrant une sensibilité optimisée.

Le but précédemment énoncé est atteint par un dispositif de mesure de pression MEMS et/ou NEMS comprenant une membrane définissant avec un substrat une cavité et un élément de transmission de la déformation de la membrane monté mobile en rotation au niveau d'une première extrémité sur le substrat autour d'un axe sensiblement parallèle à la membrane et rendu solidaire de la membrane au niveau d'une deuxième extrémité et un ou des détecteurs du déplacement en rotation de l'élément de transmission disposés au niveau de la première extrémité de l'élément de transmission, ce ou ces détecteurs pouvant être de type jauge de contrainte suspendue (i.e. une jauge suspendue dans l'espace par ses deux extrémités), de type capacitif ou de type résonant. L'élément de transmission forme un bras de levier, l'effet sur le ou les détecteurs est ainsi amplifiée, ce qui permet d'optimiser la sensibilité du capteur de pression. Le capteur ainsi réalisé peut, soit offrir des performances améliorées, soit une taille réduite à performance égale.

En outre, la membrane et le ou les détecteurs sont découplés, le ou les détecteurs n'étant pas directement sur la membrane, il devient alors possible d'optimiser la membrane et le ou les détecteurs séparément.

Il est de plus relativement aisé de faire des mesures différentielles quel que soit le type de détecteur utilisé.

En d'autres termes, on utilise un bras de levier qui permet de transmettre et d'amplifier le signal émis la membrane au(x) détecteur(s) et de découpler géographiquement et mécaniquement la membrane et le ou les détecteurs.

Le capteur de pression selon l'invention peut alors être réalisé avec les technologies de fabrication de capteurs inertiels MEMS ou NEMS en technologie de surface, il devient alors aisé d'associer différents types de capteurs sur un même substrat.

La présente invention a alors pour objet un dispositif de mesure de pression MEMS et/ou NEMS comportant au moins une membrane déformable suspendue sur un substrat, une des faces de la membrane étant destinée à être soumise à la pression à mesurer, des moyens de détection de la déformation de la membrane, lesdits moyens de détection étant disposés au moins partiellement sur le substrat et des moyens de transmission de la déformation de la membrane, aux moyens de détection, lesdits moyens de transmission étant indéformables, lesdits moyens de transmission étant suspendu au dessus de la membrane, lesdits moyens de transmission étant articulés en rotation sur le substrat autour d'un axe sensiblement parallèle au plan de la membrane et étant disposés en regard d'une face de la membrane opposée à la face destinée à être soumise à la pression à mesurer de telle sorte qu'au moins au-delà d'une pression donnée, lesdits moyens de transmission et la membrane soient solidaires en déplacement et de sorte que les moyens de transmission transmettent aux moyens de détection, de manière amplifiée, la déformation ou la contrainte issue de la déformation de la membrane.

On entend par "moyens de transmission indéformable", des moyens de transmission, par exemple une poutre, présentant une raideur supérieure à au moins 10 à 100 fois la raideur de la membrane et des moyens de détection.

En outre, le déplacement de la membrane correspond à sa déformation sous l'effet de la pression.

On entend par rotation aussi bien un mouvement du bras issu d'une torsion, obtenu par exemple par une poutre sollicitée en torsion, qu'un mouvement du bras issu d'une flexion, par exemple obtenu par une poutre de flexion, une flexion de la poutre décrivant une partie de la rotation dudit bras.

Les moyens de transmission sont solidaires en mouvement de la membrane au moins au-delà de la pression donnée, avantageusement dans une zone de déformation maximale de la membrane.

Par exemple, les moyens de transmission comportent au moins un bras longitudinal comportant au moins une première extrémité au niveau de laquelle se situent les moyens de détection et une deuxième extrémité au niveau de laquelle le bras est solidaire en déplacement de la membrane au moins au-delà de la pression donnée.

Dans un mode de réalisation, la deuxième extrémité du bras est solidaire mécaniquement de la membrane quelle que soit la valeur de la pression.

Dans un autre mode de réalisation, un espace est prévu entre la deuxième extrémité du bras et la membrane pour une pression inférieure à la pression donnée. De préférence, le bras est relié électriquement à la membrane.

Par exemple, la pression donnée est inférieure ou égale à la pression minimale à mesurer.

Dans un exemple de réalisation, le bras longitudinal est solidaire de la membrane par l'intermédiaire d'une liaison souple suivant l'axe longitudinal du bras et rigide suivant un axe de déformation de la membrane.

Selon un mode de réalisation, les moyens de transmission comportent moins une poutre de torsion reliant la première extrémité du bras longitudinal aux moyens de détection, orthogonale au bras longitudinal, l'axe de rotation étant formé par ladite poutre de torsion qui est ancrée d'une part à la première extrémité du bras et d'autre part, au substrat et aux moyens de détection.

La poutre de torsion peut présenter une section variable. Avantageusement, la section de la poutre de torsion est plus grande au voisinage des ancrages aux des moyens de détection qu'au voisinage des ancrages au substrat, ce qui permet de rigidifier lesdits ancrages.

Dans un autre mode de réalisation, les moyens de transmission comportent au moins une poutre de flexion sensiblement parallèle au bras longitudinal, l'axe de flexion étant formé par ladite poutre de flexion qui est ancrée d'une part au bras longitudinal et d'autre part au substrat. Avantageusement, la section de la poutre de flexion est inférieure à celle du bras de transmission.

Dans un exemple de réalisation particulièrement intéressant, le bras longitudinal présente un motif en « U », ledit motif comportant deux extrémités correspondant aux dites premières extrémités du bras, ces dernières étant reliées respectivement aux moyens de détection par l'intermédiaires de poutres d'extension latérales.

On pourrait envisager que la poutre de flexion comporte une seule première extrémité munie d'une seule poutre d'extension latérale

Selon une caractéristique additionnelle, le dispositif peut comporter des moyens pour rigidifier la membrane. Les moyens de rigidification forment par exemple des zones de surépaisseur sur la membrane, par exemple disposées radialement ou en nid d'abeille.

Selon une autre caractéristique additionnelle, le dispositif peut comporter un contrepoids fixé sur le bras au niveau de la première extrémité du bras.

Selon une autre caractéristique additionnelle, le dispositif peut comporter plusieurs membranes déformables soumises à la même pression, les moyens de transmission étant solidaires de toutes les membranes.

Selon une autre caractéristique additionnelle, le dispositif peut comporter une butée disposée en regard de la membrane à l'opposé de la face de la membrane soumise à la pression de sorte à limiter sa déformation.

Selon une autre caractéristique additionnelle, le dispositif peut comporter un capot sur le substrat et définissant une cavité autour de la membrane à l'opposé de la face soumise à la pression à mesurer.

Par exemple, la mise en communication de la face de la membrane soumise à la pression à mesurer et l'environnement dont la pression est à mesurer est réalisée à travers le capot et/ou entre le capot et le substrat.

Selon un mode de réalisation, les moyens de détection comportent au moins une jauge de contrainte suspendue reliée par une extrémité au substrat par un plot d'ancrage et par une autre extrémité à la poutre de torsion ou au bras de transmission.

Par exemple, la jauge de contrainte est choisie parmi une jauge piézorésistive, une jauge piézoélectrique et une jauge résonante dite résonateur.

Dans un exemple de réalisation, les moyens de détection peuvent comporter deux jauges de contrainte fixées par une extrémité sur la poutre de torsion de part et d'autre de celle-ci et par une autre extrémité au substrat par des plots d'ancrage. Avantageusement ces jauges sont disposées symétriquement par rapport au bras de transmission. En variante, les jauges peuvent être également disposées du même côté.

Dans un autre exemple de réalisation, les moyens de détection comportent deux jauges de contrainte fixées par une extrémité à au moins une des premières extrémités du bras de transmission au voisinage et de préférence au plus prés, de l'axe de torsion de part et d'autre de celui-ci et par une autre extrémité au substrat par des plots d'ancrage.

Avantageusement, les plots d'ancrage comportent un contact électrique.

Dans un autre mode de réalisation, les moyens de détection comportent au moins un résonateur relié par une première extrémité à la poutre de torsion et par une autre extrémité à un plot d'ancrage sur le substrat, des moyens d'excitation du résonateur et des moyens de détection de la fréquence de résonance du résonateur.

Dans un autre mode de réalisation, les moyens de détection sont du type à variation de capacité. Par exemple, les moyens de détection comportent au moins une première électrode fixe sur le substrat et au moins une première électrode mobile solidaire des moyens de transmission et en regard de l'électrode fixe.

Le dispositif de mesure de pression peut comporter des deuxièmes électrodes fixes et des deuxièmes électrodes mobiles, lesdites deuxièmes électrodes étant situées à l'opposé des premières électrodes par rapport à l'axe de rotation de sorte à former un dispositif de mesure différentiel.

Avantageusement, le dispositif de mesure peut comporter des moyens actifs de compensation de la pression statique. Les moyens actifs de compensation de la pression statique peuvent comporter une paire d'électrodes, l'une d'entre elles étant solidaire des moyens de transmission, ladite paire étant située du côté de la membrane par rapport à l'axe de rotation des moyens de transmission leur articulation en rotation sur le substrat.

En variante, les moyens actifs de compensation de la pression statique comportent une électrode formée au-dessous de la membrane sur le substrat.

De manière avantageuse, le dispositif de mesure peut comporter des moyens pour effectuer des autotests et/ou une auto-calibration. Les moyens pour effectuer des autotests et/ou une auto-calibration peuvent comporter au moins une électrode solidaire des moyens de transmission à l'opposée de la membrane par rapport à l'articulation des moyens de transmission sur le substrat.

Dans un exemple de réalisation, la cavité est étanche. Par exemple, le vide est réalisé dans ladite cavité étanche pour former un capteur de pression absolue. Un matériau getter peut être déposé sur le capot au niveau de la zone du capot située au-dessus de la membrane et/ou sur le substrat en regard du capot.

Dans un autre exemple de réalisation, la cavité est connectée à l'environnement extérieur pour former un capteur de pression relative ou un microphone. La connexion entre la cavité et l'environnement extérieur peut être réalisée au moyen d'un évent formé travers le capot ou entre le capot et le substrat.

La présente invention a également pour objet un ensemble MEMS et/ou NEMS comportant au moins un dispositif de mesure de pression selon la présente invention et au moins un capteur inertiel réalisé sur et dans le même substrat.

La présente invention a également pour objet un procédé de réalisation d'un dispositif de mesure de pression selon la présente invention, comportant les étapes :
- a) fabrication par dépôt et gravure sur un substrat des différents éléments du capteur hormis le capot,
- b) fabrication du capot sur le substrat ou report et scellement du capot sur le substrat,
- c) libération de la membrane.

Le scellement du capot sur le substrat a lieu par exemple sous vide.

Au cours de l'étape a) ou b), le procédé peut comporter une sous-étape de dépôt d'un matériau getter sur une face intérieure du capot et/ou du substrat.

Les reprises de contacts sont par exemple réalisées au moyen de via en face avant et/ou en face arrière.

La présente invention a également pour objet un procédé de réalisation d'un ensemble de capteurs comportant les étapes du procédé selon la présente invention, dans lequel lors de l'étape a) au moins un capteur inertiel est réalisé simultanément.

### BRÈVE DESCRIPTION DES DESSINS

La présente invention sera mieux comprise à l'aide de la description qui va suivre et des dessins en annexe sur lesquels :

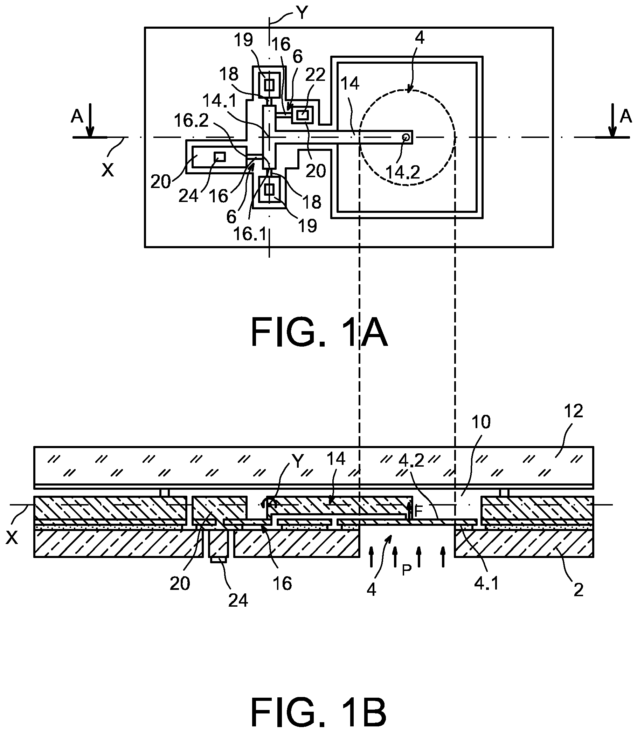

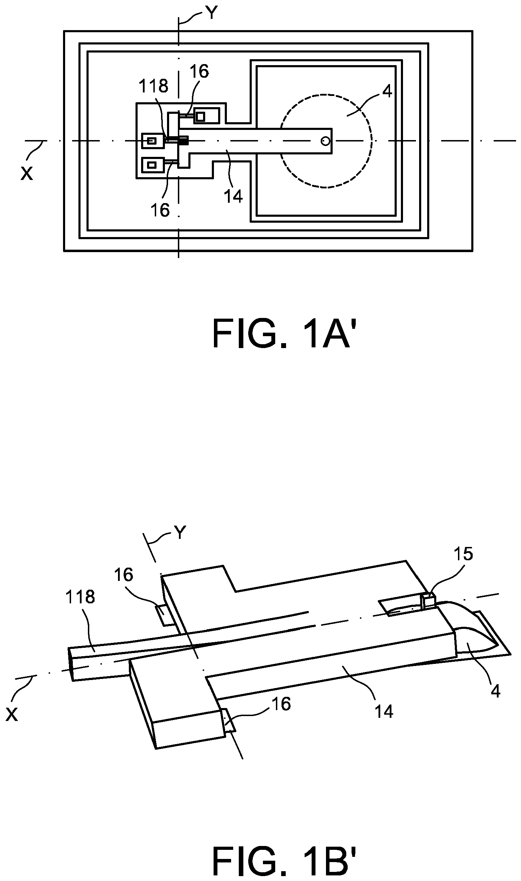

- les figures 1A et 1B sont des vues de dessus et en coupe le long de la ligne A-A respectivement d'un exemple de réalisation d'un dispositif de mesure de pression à détection par jauge de contrainte suspendue selon l'invention,
- la figure 1A' est une variante de réalisation de la figure 1A, dans laquelle l'articulation en rotation est réalisée par une poutre déformable en flexion,
- la figure 1B' est une vue en perspective d'une variante de réalisation de la figure 1A', dans laquelle une articulation souple suivant l'axe X et rigide suivant l'axe Z entre la membrane et le bras de transmission est réalisée,
- les figures 2A et 2B sont des vues de dessus et en coupe longitudinale respectivement d'un exemple de réalisation d'un dispositif de mesure de pression à détection capacitive selon l'invention,
- la figure 3 est une vue de dessus d'un exemple de réalisation d'un dispositif de mesure de pression mettant en oeuvre des mesures capacitives différentielles,
- la figure 4 est une vue de dessus d'un autre exemple de réalisation d'un dispositif de mesure de pression à détection par jauge de contrainte comportant plusieurs membranes,
- les figures 5A et 5B sont des vues de dessus et en coupe le long de la ligne B-B respectivement d'un autre exemple de réalisation d'un dispositif de mesure de pression à détection par jauge de contrainte selon l'invention, présentant une butée mécanique à même de limiter les risques de surpression pouvant endommager le capteur,
- les figures 6A et 6B sont des vues de dessus et en coupe le long de la ligne C-C respectivement d'un autre exemple de réalisation d'un dispositif de mesure de pression à détection par jauge de contrainte selon l'invention présentant une rigidification localisée de la membrane déformable,
- la figure 7 est une vue de dessus d'un autre exemple de réalisation d'un dispositif de mesure de pression à détection par jauge de contrainte offrant une sensibilité réduite aux accélérations,
- la figure 8 est une vue de dessus d'un autre exemple de réalisation d'un dispositif de mesure de pression résonant,
- la figure 9 est une vue en coupe longitudinale d'un autre exemple d'un capteur selon l'invention à détection par jauge de contrainte, comportant une couche getter,
- les figures 10 et 11 sont des vues en coupe longitudinale de variantes de réalisation d'un dispositif de mesure de pression relatif ou microphone selon l'invention à détection par jauge de contrainte, munies d'évent,
- les figures 12A et 12B sont des vues de dessus et en coupe le long de la ligne D-D respectivement d'une variante de réalisation du dispositif de mesure de pression des figures 1A et 1B,
- la figure 13 est une vue en coupe longitudinale d'un ensemble intégrant un dispositif de mesure de pression selon l'invention à détection par jauge de contrainte et un capteur inertiel,
- la figure 14 est une vue en coupe longitudinale d'une variante de réalisation de l'ensemble de la figure 13 cette fois-ci avec des contacts électriques traversant du côté opposé de la membrane,
- les figures 15A à 15H sont des vues de dessus et en coupe longitudinale de différentes étapes de réalisation d'un dispositif de mesure de pression selon l'invention,
- la figure 16 est une vue de dessus d'un autre exemple d'un capteur selon l'invention à détection par jauge de contrainte, permettant la compensation de la pression statique et/ou l'auto-calibration et/ou l'autotest du capteur de pression;
- les figures 17A et 17B sont des vues de dessus et en coupe longitudinale le long du plan de coupe E-E d'un autre exemple d'un capteur selon l'invention à détection par jauge de contrainte, permettant la compensation de la pression statique et/ou l'auto-calibration et/ou l'autotest du capteur de pression;

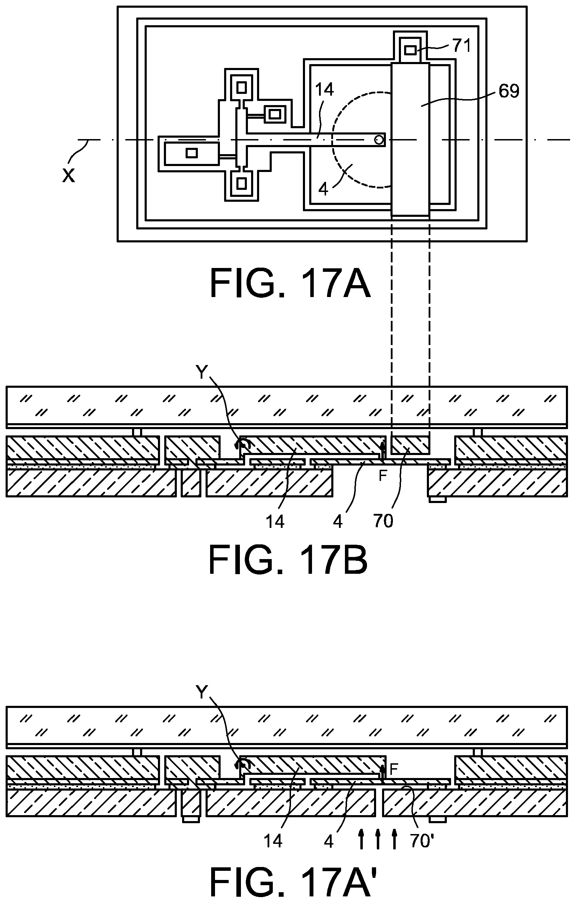

- la figure 17A' est une vue en coupe longitudinale d'un autre exemple d'un capteur selon l'invention à détection par jauge de contrainte, permettant la compensation de la pression statique et/ou l'auto-calibration et/ou l'autotest du capteur de pression;

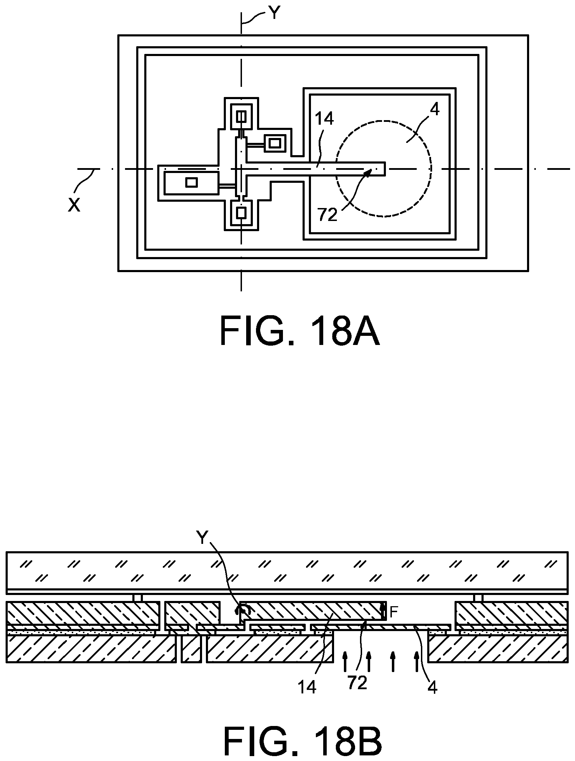

- les figures 18A et 18B sont des vues de dessus et en coupe longitudinale le long du plan de coupe E-E d'un autre exemple d'un capteur selon l'invention à détection par jauge de contrainte, comportant des moyens passifs de compensation de la pression statique;

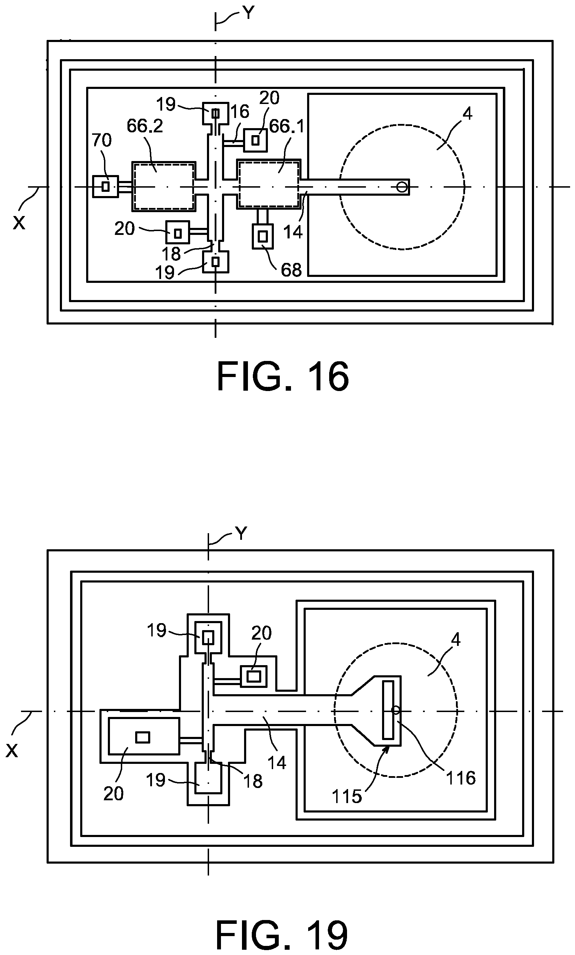

- la figure 19 est une vue de dessus d'un exemple de réalisation d'un dispositif de mesure de pression mettant en oeuvre des mesures piézorésistives et comportant une articulation souple suivant l'axe X et rigide suivant l'axe Z entre la membrane et le bras de transmission.

### EXPOSÉ DÉTAILLÉ DE MODES DE RÉALISATION PARTICULIERS

Dans la description qui va suivre, les capteurs sont de type MEMS et/ou NEMS, cependant ils seront désignés uniquement par le terme " capteur" à des fins de simplicité.

Les éléments et parties ayant la même fonction et la même forme seront désignés par les mêmes références.

Sur les figures 1A et 1B sont des vues de dessus et en coupe respectivement d'un exemple de réalisation d'un capteur de pression, comportant un substrat 2, une membrane 4 suspendue sur le substrat, la membrane étant telle qu'elle se déforme sous l'action d'une différence de pression sur ses deux faces, des moyens de détection 6 de la déformation de la membrane située sur le substrat et des moyens aptes à transmettre la déformation de la membrane 4 aux moyens de détection 6.

Dans la présente demande, on entend par « substrat » par soucis de simplification, le substrat support 2 et les couches disposées sur ce substrat support telles que par exemple la ou les couches dans laquelle ou lesquelles sont réalisées la membrane et le bras de transmission.

La membrane 4 est soumise sur une de ses faces 4.1 à la pression P que l'on souhaite mesurer, dans la représentation de la figure 1B, il s'agit de la face inférieure de la membrane. L'autre face 4.2 est soumise à une pression de référence qui est réalisée dans une cavité 10 formée entre la membrane 4 et un capot 12. Dans le cas d'un capteur de pression absolue, le vide est réalisé dans la cavité 10. Le capot 12 est scellé sur le substrat 2 soit au moyen d'un cordon de scellement 13 ou par scellement direct, du type sans cordon.

Dans l'exemple représenté, la membrane 4 a la forme d'un disque (en pointillés sur la figure 1A) mais elle pourrait présenter toute autre forme, comme une forme carrée, hexagonale....

Les moyens pour transmettre la déformation de la membrane 4 aux moyens de détection 6 sont formés par un bras 14 d'axe longitudinal X, monté mobile en rotation par rapport au substrat au niveau d'une première extrémité longitudinale 14.1, l'axe de rotation Y est sensiblement parallèle à la membrane et au plan du substrat. En outre, le bras 14 est rendu solidaire en mouvement de la membrane au niveau de sa deuxième extrémité longitudinale 14.2. Le bras est indéformable, i.e. il présente une rigidité supérieure à au moins 10 à 100 fois la rigidité de la membrane et des moyens de transmission. Le bras est suspendu au-dessus de la membrane, i.e. il est disposé au dessus de la membrane et un espace existe entre le bras 14 et la membrane, le seul contact entre le bras et la membrane se fait au niveau de la deuxième extrémité longitudinale 14.2 du bras 14.

Le bras a, dans l'exemple représenté, la forme d'une poutre rigide à section rectangulaire. La poutre pourrait en variante avoir une forme trapézoïdale.

De préférence, la deuxième extrémité longitudinale 14.2 du bras 14 est solidaire de la membrane au niveau ou proche de la zone présentant la déformation maximale. Le déplacement du bras autour de son axe de rotation Y vu par les moyens de détection est alors maximal et la sensibilité du capteur est alors optimisée.

Il est bien entendu que la partie du bras 14 solidaire de la membrane pourrait être une autre partie que la deuxième extrémité longitudinale 14.2, entre la première 14.1 et la deuxième 14.2 extrémité longitudinale.

Les moyens de détection 6 sont disposés sur le substrat de sorte qu'ils détectent le déplacement de la première extrémité longitudinale 14.1 du bras, ce déplacement étant proportionnel à l'amplitude de déformation de la membrane 4. Le bras 14 formant un bras de levier, la contrainte vue par les moyens de détection 6 est amplifiée par rapport à la déformation de la membrane. Dans le cas d'une mesure par jauge, le bras de levier augmente la contrainte exercée sur les jauges mais diminue l'amplitude de déformation par rapport à l'amplitude de déformation de la membrane du fait de la loi de conservation des moments.

Dans une mode de réalisation représenté sur la figure 1A, la liaison pivot d'axe Y est formée par une poutre 18 d'axe Y sollicitée en torsion autour de l'axe Y. La poutre est ancrée au niveau de chacune de ses extrémités sur le substrat. Dans la suite de la description, la poutre 18 sera désignée" axe de torsion 18 ". Avantageusement, cette poutre 18 comprend une partie rigide en flexion suivant l'axe X pour transmettre toute la contrainte sur laquelle sont fixées les jauges, et une partie formant axe de torsion à ses extrémités également rigide en flexion suivant l'axe X de la contrainte.

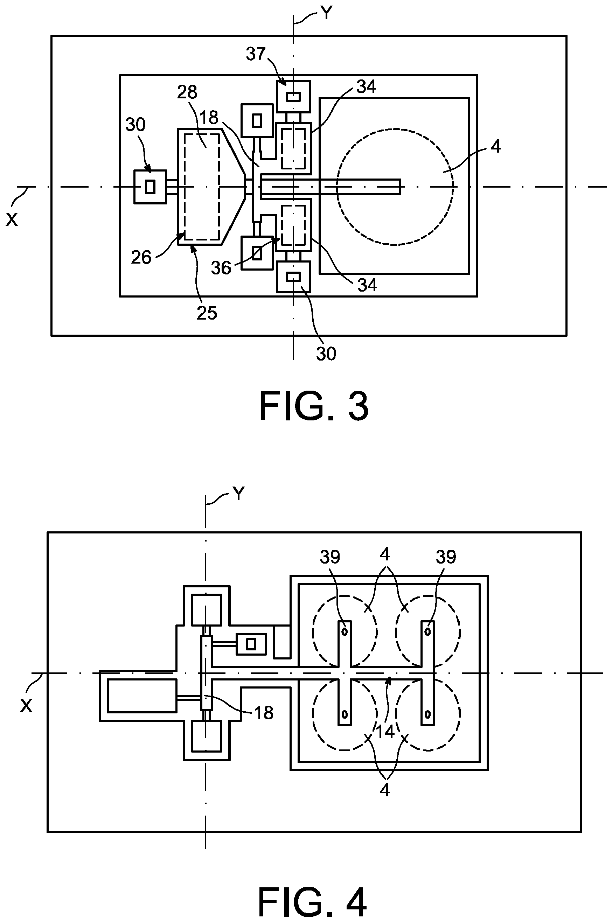

Dans un autre mode de réalisation et comme cela est représenté sur les figures 1A' et 1B', l'articulation en rotation peut être formée par une ou plusieurs poutres 118 sollicitées en flexion d'axe parallèle à celui du bras 14. Sur la figure 1B', on peut voir la poutre 118 en état de flexion en outre, dans cette variante une liaison 15 souple suivant l'axe X et rigide suivant l'axe Z entre la membrane et le bras de transmission 14 est réalisée de manière similaire à la réalisation de la figure 3. De préférence, l'élément de transmission a sensiblement la forme d'un U, le fond du U étant solidarisé à la membrane 4 et les extrémités libres des deux branches formant les premières extrémités et sollicitent les moyens de détection.

Sur les dispositifs représentés sur les figure 1A et 1B et 1A' et 1B', les moyens de détection 6 sont formés par deux jauges de contrainte suspendues 16 fixées chacune par une première extrémité 16.1 sur l'axe de torsion 18 et par une deuxième extrémité 16.2 à un plot d'ancrage 20 au substrat 2. La contrainte amplifiée par le bras 14 s'applique alors sur les extrémités longitudinales de la jauge.

La raideur de la poutre 18 dans la direction transversale par rapport à l'axe Y est de préférence au moins 10 fois supérieure à la raideur en compression de la ou des jauges, ce qui permet d'éviter une déformation de la poutre et une réduction de la déformation transmise à la poutre.

Les jauges 16 sont disposées de part d'autre de l'axe de rotation et du bras 14.

Les moyens de détection pourraient ne comporter qu'une seule jauge de contrainte. La mise en oeuvre de deux jauges de contrainte permet d'effectuer des mesures différentielles, rendant le dispositif moins sensible thermiquement.

Sur les plots d'ancrage des jauges sont formés des contacts électrique 22, 24. Sur l'un des plots 20, le contact électrique 24 est réalisé en face arrière du substrat 2, du côté membrane déformable, et peut servir pour polariser la jauge de contrainte 16. Le contact est connecté à la jauge au moyen d'un contact traversant ou via ou TSV (Through Silicon Vias en terminologie anglo-saxonne) et par l'intermédiaire du plot d'ancrage 20.

Les jauges de contrainte peuvent être en matériau piézoélectrique ou en matériau piézorésistif.

Les jauges sont orientées de sorte que leur axe sensible soit sensiblement parallèle au bras de liaison et donc qu'il soit sensiblement orthogonal à l'axe de rotation du bras de liaison. Par ailleurs, la ligne neutre de chaque jauge est disposée au-dessus ou au dessous de l'axe de rotation du bras de transmission. Pour cela les jauges peuvent présenter une épaisseur inférieure à celle de la poutre de torsion et/ou de flexion. Par exemple pour obtenir cette épaisseur plus faible à partir des mêmes couches, on peut déposer une surépaisseur sur lesdites poutres.

Nous allons maintenant expliquer le fonctionnement du capteur de pression des figures 1A et 1B.

Lorsqu'une différence de pression apparait entre la face 4.2 de la membrane 4 qui est en contact avec l'intérieur de la cavité 10, qui est à la pression de référence, et la face 4.1 de la membrane, qui est en contact avec l'environnement dont on souhaite mesurer la pression, la membrane se déforme. La déformation se fait soit vers l'intérieur de la cavité, soit vers l'extérieur de la cavité en fonction de la valeur de la pression à mesurer par rapport à la pression de référence.

Cette déformation induit une force sur le bras 14 solidaire de la membrane, ce qui a pour effet de générer une contrainte dans les jauges de contrainte 16. Cette contrainte est amplifiée du fait du bras et de son pivotement autour de l'axe Y. La contrainte subie par les jauges 16 est alors mesurée par exemple, en mesurant la variation de résistance électrique des jauges dans le cas de jauges piézorésistives. Ces mesures permettent alors de déterminer la différence de pression vue par la membrane et la pression de l'environnement.

L'amplification de la contrainte par le bras de levier sera d'autant plus importante que la longueur du bras entre le point d'application de la force par la membrane et l'axe de rotation Y sera grande, que l'axe de rotation sera proche du point d'application de la contrainte sur la jauge. La contrainte sera également d'autant plus élevée que la section de la jauge (épaisseur, largeur) sera petite.

Ainsi, la sensibilité du capteur est augmentée. Il est donc possible d'offrir des capteurs plus performants ou alors de réduire la taille des capteurs, par exemple en réduisant la surface de la membrane, tout en conservant la même performance.

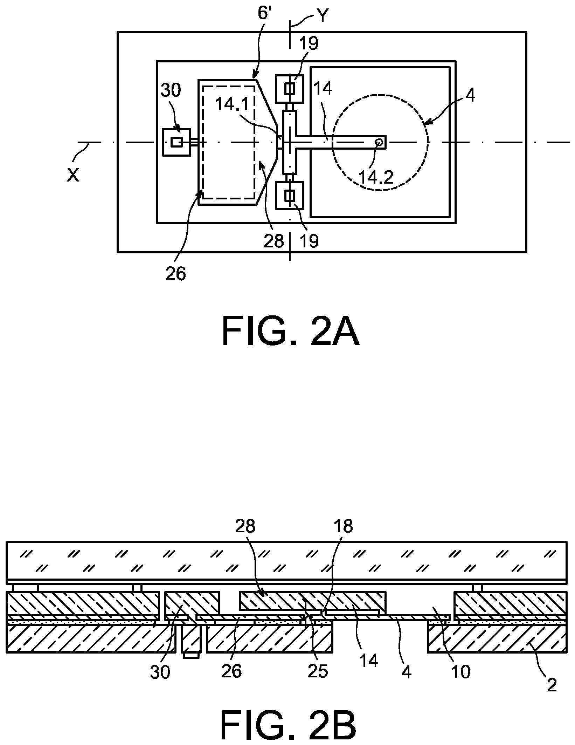

Sur les figures 2A et 2B, on peut voir un capteur de pression selon la présente invention dans lequel la détection se fait par des moyens capacitifs.

Les moyens de détection 6' sont de type capacitif, i.e. la détection est obtenue par mesure d'une variation de capacité d'un condensateur 25. Les moyens de détection 6' comportent une électrode fixe 26 située sur le substrat 2 et une électrode mobile 28 solidaire du bras 14, et faisant face à l'électrode fixe 26. L'électrode mobile 28 est fixée à la première extrémité 14.1 du bras 14. L'électrode fixe 26 est connectée à un contact 30 et l'électrode mobile est reliée au contact électrique formé sur un des plots d'ancrage de l'axe de torsion 18.

Lorsque la membrane 4 se déforme, le bras 14 entraîne avec lui l'électrode mobile 28, qui se déplace par rapport à l'électrode fixe 26. La distance d'entrefer entre les deux électrodes 26, 28 varie, cette variation est représentative de la déformation de la membrane 4 et donc de la pression de l'environnement.

Grâce à la mise en oeuvre du bras 14, le déplacement de l'électrode mobile 28 peut être amplifié par rapport à celui de la membrane 4. Ainsi pour une pression donnée, la variation de capacité est augmentée. La sensibilité du capteur de pression est donc augmentée.

Sur la figure 3, on peut voir un exemple de réalisation d'un capteur de pression à détection capacitive, permettant une mesure différentielle.

Ce capteur diffère de celui des figures 2A et 2B, en ce qu'il comporte au moins un condensateur à capacité variable supplémentaire 32 pour permettre une mesure d'une deuxième variation de capacité. Dans l'exemple représenté, il s'agit de deux condensateurs supplémentaires 32, donc les électrodes mobiles 34 sont situées entre l'axe de torsion 18 et la membrane 4 et sont reliés à l'axe de torsion 18 de part et d'autre du bras 14. Des électrodes fixes 36 (représentées en pointillés) sont situées en regard des électrodes mobiles 34 sur le substrat 2. Les électrodes fixes 36 sont connectées à des plots de contact 37 et 30.

Il est à noter que, lorsque la capacité du condensateur 25 augmente, celle des condensateurs supplémentaires 32 diminue. De préférence, la distance entre l'axe de torsion 18 et l'électrode 28 est la même que celle entre l'axe de torsion est les électrodes 34 afin qu'elles voient la même amplification. Pour obtenir une mesure différentielle, la surface de l'électrode 28 est choisie égale à la somme des surfaces des deux électrodes 34.

Sur la figure 4, on peut voir une variante de réalisation du capteur de pression des figures 1A et 1B, comportant plusieurs membranes 4, le bras 14 étant relié à chacune des membranes 4. Dans l'exemple représenté, deux membranes sont disposées de chaque côté de l'axe X, et le bras comporte deux éléments transversaux 39 parallèles, s'étendant de part et d'autre du bras 14 et reliés au voisinage de leurs extrémités à une membrane 4.

Les déformations des quatre membranes 4 appliquent un effort sur le bras 14, or la surface totale des quatre membranes étant supérieure à celle d'une seule membrane, la force appliquée sur le bras et donc sur les jauges est augmentée. Cette réalisation est particulièrement intéressante pour les capteurs à jauge de contrainte, telles que les jauges piézorésistives ou résonantes.

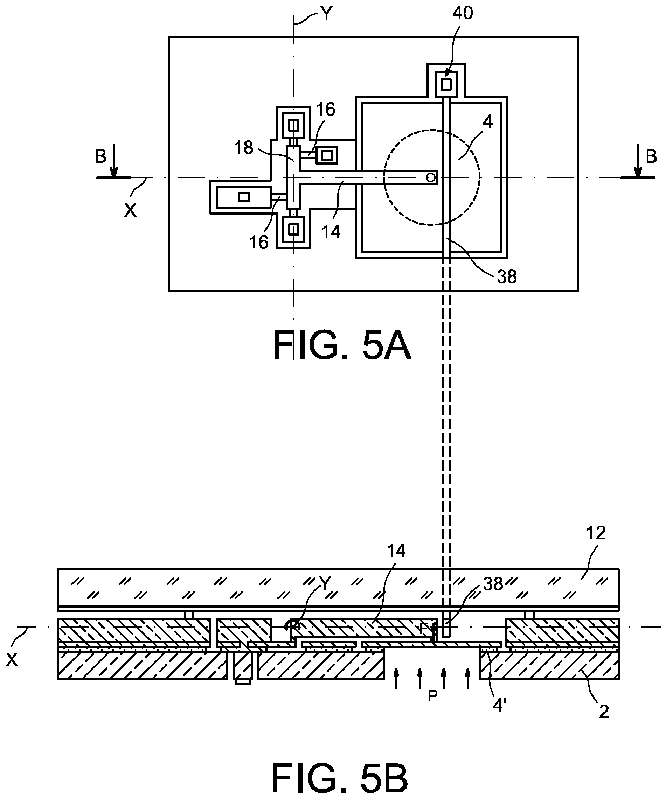

Sur les figures 5A et 5B, on peut voir une autre variante de réalisation du capteur de pression des figures 1A et 1B. Le capteur comporte des moyens de butée 38 disposés entre la membrane 4 et le capot.

La butée 38 sert à limiter le déplacement de la membrane 4, et donc celui du bras 14, pour protéger les jauges 16. En effet, en cas de choc de pression, la pression vue par la membrane peut sortir de la gamme de mesure prévue à la construction, et la membrane 4 via le bras 14 peut appliquer une contrainte supérieure à la contrainte que peut supporter la jauge ou les jauges 16.

Il est possible de fixer simplement le niveau de pression à partir de laquelle le déplacement de la membrane et donc du bras, est limitée, en positionnant la butée 38 plus ou moins proche de la zone de la membrane présentant la déformation maximale.

On peut envisager que la butée soit au dessus du bras et forme directement une butée pour le bras, par exemple dans le cas où la butée est réalisée directement par la capot 12 ou sur le capot au-dessus du bras.

Un contact électrique 40 peut être ajouté sur le plot d'ancrage de la butée afin de contrôler le potentiel de la butée, par exemple la butée pourrait être au potentiel de la membrane, ce qui permet d'éviter le risque de court-circuit en cas de contact de la membrane sur la butée et le risque d'une attraction électrostatique parasite de la membrane vers la butée.

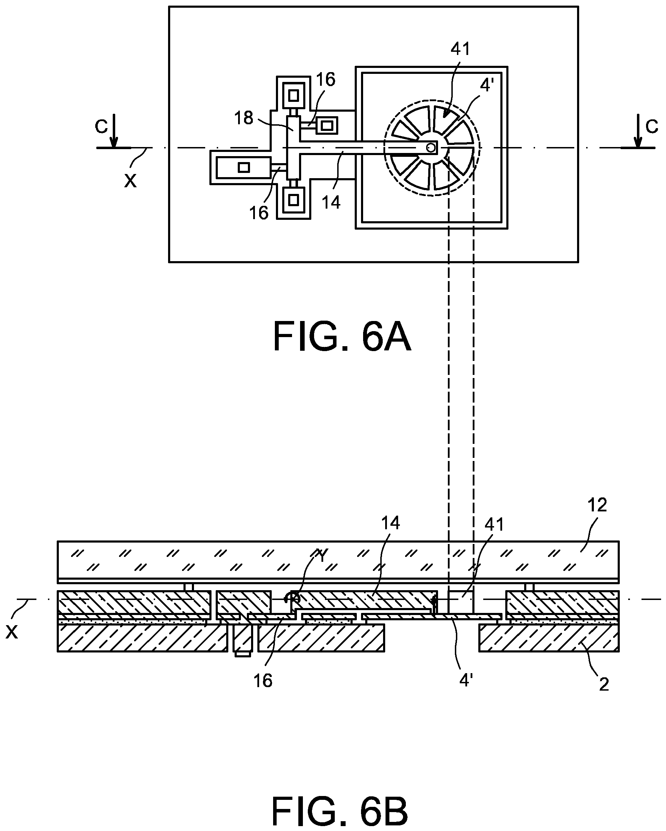

Sur la figures 6A et 6B, on peut voir une autre variante de réalisation du capteur de pression des figures 1A et 1B. La membrane 4' présente une rigidité augmentée localement afin de réduire la déformation de la membrane 4 au profit de la contrainte appliquée sur le bras 14 et sur la ou les jauges 16.

Dans l'exemple représenté, la membrane 4 est rigidifiée localement en ajoutant des surépaisseurs radiales 41 sur la membrane 4, présentant une structure similaire à des baleines de parapluie. Une structure en nid d'abeille peut également convenir ou tout autres moyen augmentant la rigidité de la membrane. Le niveau de rigidification est choisi afin d'éviter de rendre le capteur trop sensible aux accélérations.

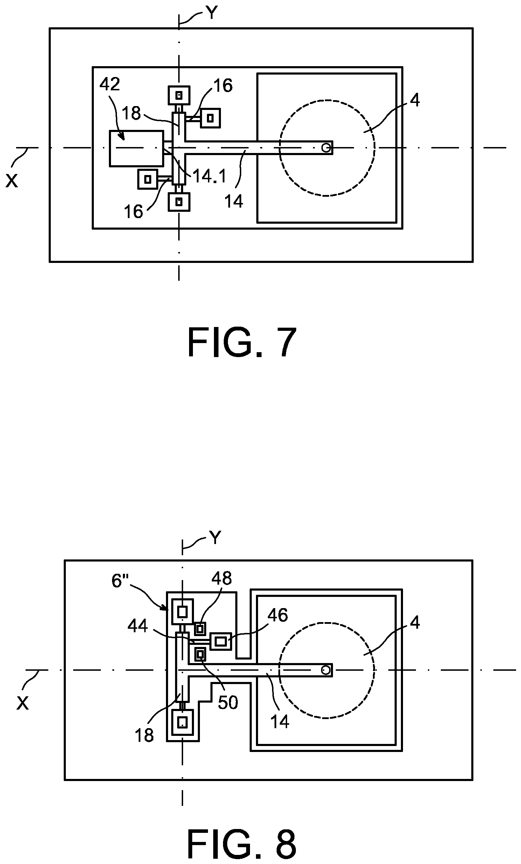

Sur la figure 7, on peut voir une autre variante de réalisation du capteur des figures 1A et 1B, comportant un contrepoids 42 fixé au bras 14 entre l'axe de torsion 18 et la première extrémité longitudinale 14.1 du bras 14 et compensant le poids du bras 14 et/ou la membrane 4.

De préférence et comme cela est représenté sur la figure 7, le contrepoids 42 est fixé sur la première extrémité 14.1 du bras 14. Le contrepoids 42 a pour effet de déplacer le centre de gravité de l'ensemble membrane 4 et bras 14 auquel s'ajoute le contrepoids 42 vers l'axe de rotation Y, de sorte qu'il soit le plus porche possible de l'axe de rotation Y, voire sur l'axe de rotation Y.

Le capteur de pression est alors moins sensible, voire insensible à l'accélération hors-plan, i.e. à l'accélération tendant à faire défléchir la membrane.

Sur la figure 8, on peut voir un autre exemple de réalisation d'un capteur de pression selon l'invention, dans lequel les moyens de détection 6" sont de type résonant. Les moyens de détection 6" comportent un résonateur 44 suspendu entre l'axe de torsion 18 et un plot d'ancrage 46 portant un contact électrique, des moyens d'excitation 48 du résonateur 44 et des moyens de détection 50 de la variation de la fréquence de résonance du résonateur 44, i.e. de sa fréquence de résonance. Les moyens d'excitation 48 et de détection 50 sont par exemple de type capacitif et sont formés pas des électrodes. Le résonateur peut être piézoélectrique. L'excitation et la détection sont alors obtenues par des électrodes disposées sur le résonateur. On peut prévoir également un deuxième résonateur de l'autre côté de l'axe Y.

Le résonateur présente une épaisseur réduite par rapport à l'axe de torsion 18 afin d'être sensible au déplacement hors plan du bras 14.

Le fonctionnement de ce capteur est le suivant : lorsque la membrane 4 se déforme, elle applique une contrainte au bras 14 qui la transmet au résonateur 44. Celui-ci est excité par les moyens d'excitation 48 et est mis en vibration à la résonance. Du fait de la contrainte qui lui est appliquée, sa fréquence de résonance varie, cette variation est alors mesurée par les moyens de détection 50. Il est alors possible de remonter à la déformation de la membrane et donc à la pression de l'environnement.

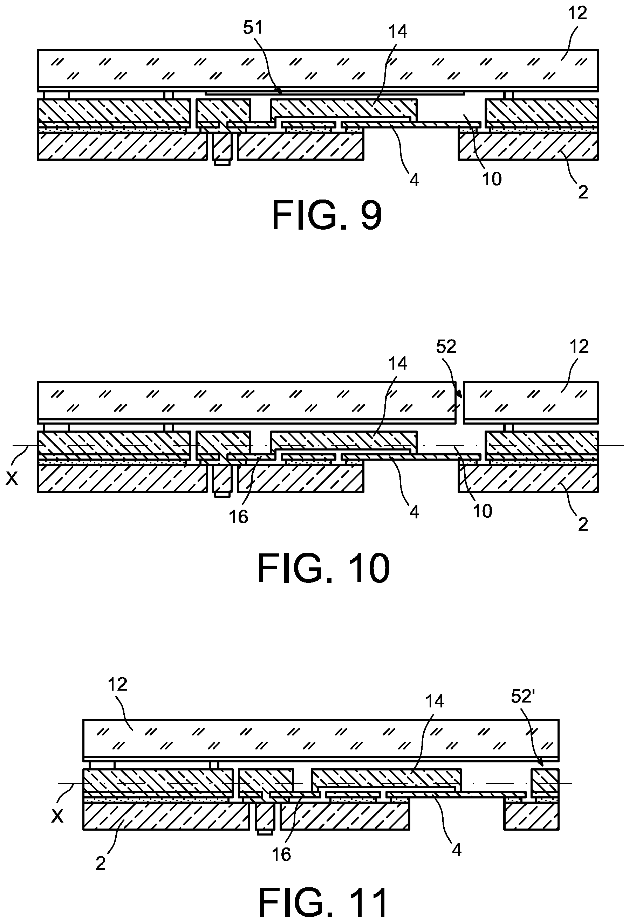

Sur la figure 9, on peut voir encore une variante de réalisation du capteur de pression absolue comportant une couche de matériau getter 51 disposée dans la cavité 10, par exemple déposée sur la face du capot situé à l'intérieur de la cavité 10. Cette couche 51 permet de stabiliser et/ou d'améliorer le vide dans la cavité 10, ce qui améliore la fiabilité et la performance du capteur.

Sur les figures 10 et 11, on peut voir une autre variante de réalisation du dispositif de mesure de pression des figures 1A et 1B dans le cas où la cavité de référence est connectée à la pression ambiante.

Sur la figure 10, un évent 52 est préférentiellement réalisé directement à travers le capot 12 par exemple par gravure ou par perçage laser.

Sur la figure 11, l'évent 52' est formé latéralement entre le capot 12 et le substrat 4, par exemple à travers le cordon de scellement.

Ces dispositifs peuvent former un capteur de pression relative ou un microphone.

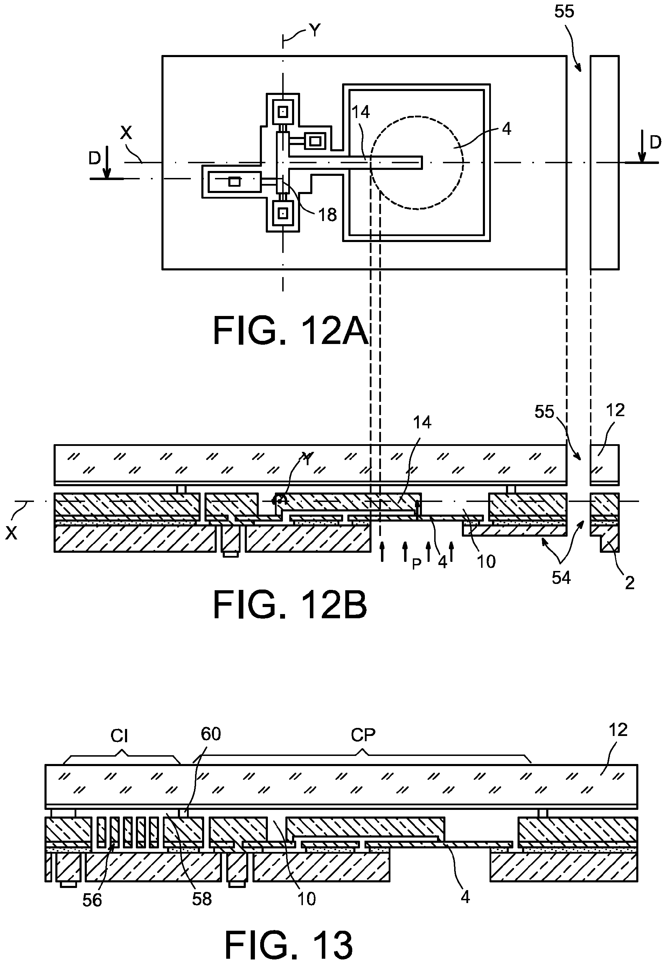

Sur les figures 12A et 12B, on peut voir encore une autre variante de réalisation du capteur de pression des figures 1A et 1B, dans lequel la face inférieure 4.2 de la membrane 4 est mise en contact avec la pression à mesurer par un conduit 54 formé dans le substrat parallèlement au plan du substrat et un conduit 55 formé à travers le capot 12 perpendiculairement au plan du capot et débouchant en face avant du capteur. Le conduit 54 peut être réalisé au moment de la réalisation de la puce, par exemple par un trait de découpe réalisé au moyen d'une scie ou par laser.

Sur la figure 13, on peut voir un exemple d'intégration d'un capteur de pression selon l'invention et d'un capteur inertiel. Cette intégration est rendue possible par le fait que le capteur de pression CP selon l'invention peut être réalisé avec les technologies des capteurs inertiels, tels que les accéléromètres ou les gyromètres.

Sur la figure 13, on peut voir le capteur de pression CP (à droite sur la représentation de la figure 13) et un capteur inertiel CI (à gauche sur la représentation de la figure 13) comportant des peignes capacitifs interdigités 56, réalisé dans le même substrat que celui du capteur de pression.

Dans l'exemple représenté, l'encapsulation du capteur inertiel CI est obtenue par la réalisation d'une cavité 58 distincte de la cavité 10 du capteur de pression, un cordon de scellement 60 les séparant. Cependant, dans le cas d'une cavité 10 fermée, il est envisageable de ne réaliser qu'une seule cavité pour les deux capteurs CP et CI.

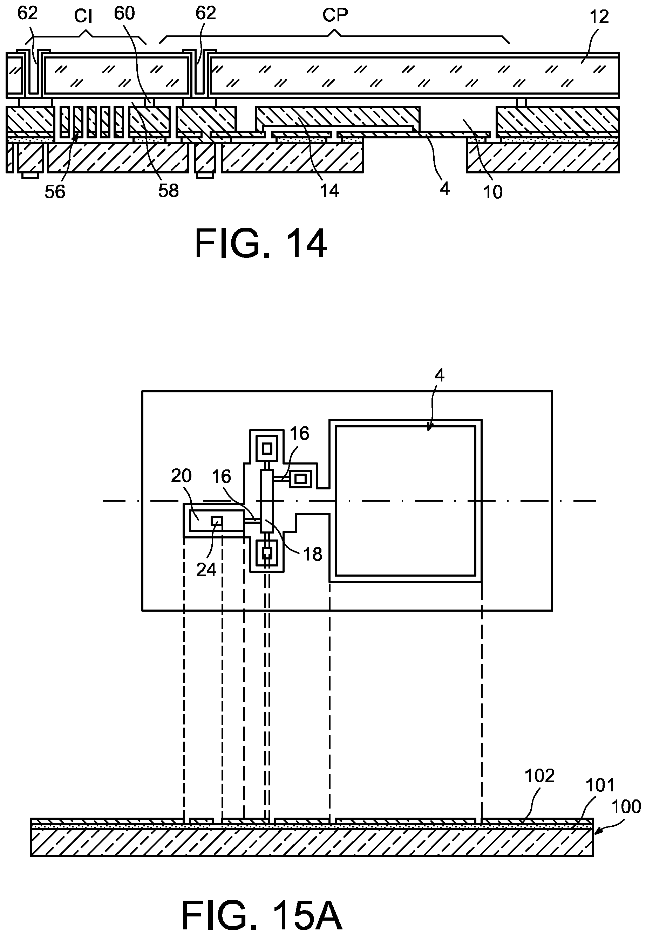

Sur la figure 14, on peut voir également un exemple d'intégration d'un capteur de pression CP et d'un capteur inertielle CI, dans lequel les reprises de contact sont réalisées en face avant par des vias (ou TSV) à travers le capot en face avant, et non en face arrière à travers le substrat comme pour les autres exemples.

Sur la figure 16, on peut voir un autre exemple de réalisation. La structure du capteur est proche de celle du capteur de la figure 1A. La détection de la déformation de la membrane est obtenue au moyen de jauges piézoélectriques.

Dans l'exemple représenté, le capteur de pression comporte des moyens de la compensation de la pression statique et/ou l'auto-calibration et/ou l'autotest du capteur de pression.

Le capteur comporte deux paires d'électrodes 66.1, 66.2 d'actionnement capacitifs, l'une 66.1 étant située entre l'axe de rotation Y et la liaison avec la membrane 4 et l'autre 66.2 étant situé de l'autre côté de l'axe de rotation Y. Une électrode, dite électrode supérieure, de chaque paire est située sur le bras et l'autre électrode, dite électrode inférieure, de chaque paire est située sur le substrat mais isolée électriquement du substrat Les électrodes inférieures sont représentées en pointillés.

Les électrodes supérieures de chaque paire sont connectées électriquement via le bras d'amplification et le plot 19. Le plot de contact 68 assure l'activation de l'électrode inférieure de la paire 66.1 et le plot de contact 70 assure l'activation de l'électrode inférieure de la paire 66.2.

Lors de l'activation des électrodes de la paire 66.1, 66.2, des forces électrostatiques apparaissent entre les l'électrode inférieure et les électrodes supérieures.

Dans la représentation de la figure 16, l'activation des électrodes 66.1 permet de déplacer le bras vers le bas et l'activation des électrodes 66.2 permet de déplacer le bras vers le haut et donc d'agir sur la déformation de la membrane.

L'activation des électrodes 66.1 provoque un pivotement du bras 14 dans le sens horaire et un déplacement de la membrane en rapprochement du substrat 2, ce qui permet d'annuler tout ou partie de la déformation de la membrane issue de cette pression statique, pour ne mesurer que les variations de pression autour de cette pression statique.

Par exemple, on peut souhaiter annuler une pression de l'ordre de 0,5 fois la pression atmosphérique.

Ceci est particulièrement intéressant dans le cas d'un capteur de pression devant mesurer de très faibles variations de pression autour d'une valeur de pression statique.

Une activation des électrodes 66.2 provoque un pivotement du bras dans le sens antihoraire et un déplacement de la membrane en éloignement du substrat 2.

L'activation des électrodes d'actionnement 66.2 permet d'effectuer des autotests. Le bon fonctionnement du capteur peut alors être vérifié en déformant la membrane 4 vers le haut par les moyens d'actionnement électrostatiques au moyen de la paire d'électrodes 66.2 et en vérifiant que les moyens de détection sont sensibles à cette déformation induite.

L'activation des électrodes d'actionnement 66.2 permet également d'effectuer une auto-calibration. Dans ce cas on calibre le capteur de pression en appliquant entre les électrodes d'actionnement 66.2 une tension connue, induisant une déformation de la membrane qui « simule » une pression de référence, permettant ainsi de recaler le signal de sortie du capteur.

On utilise les moyens de détection, des jauges piézorésistives par exemple, pour mesurer les variations de pression autour de cette pression statique compensée.

Un capteur de pression ne comportant que les moyens d'autotest et/ou de calibration ou les moyens d'annulation de la pression statique ne sort pas du cadre de la présente invention.

La mise en oeuvre de ces électrodes peut permettre d'asservir en position le bras et la membrane, en particulier dans le cas d'une détection capacitive.

De manière avantageuse, la paire d'électrodes 66.1 est située à l'opposé de l'axe de rotation par rapport à la membrane 4.

Sur la figure 17, on peut voir un autre exemple de réalisation d'un capteur de pression comportant des moyens de la compensation de la pression statique et/ou l'auto-calibration et/ou l'autotest du capteur de pression.

Dans cet exemple, l'électrode d'actionnement est telle qu'elle peut agir directement sur la membrane.

Sur les figures 17A et 17B, l'électrode d'actionnement 69 est située au dessus de la membrane, celle-ci étant réalisée dans la couche MEMS. L'électrode 69 a la forme d'une poutre s'étendant perpendiculairement à l'axe longitudinal X. dans l'exemple représentée, la poutre est encastrée l'une de ses extrémité, l'encastrement 71 formant également une prise de contact électrique. En variante, l'électrode 69 peut s'étendre sur toute la surface de la membrane en dehors de la poutre de transmission). De manière avantageusement, l'électrode d'actionnement 69 est encastrée à ses deux extrémités longitudinales.

Dans un autre exemple, l'électrode d'actionnement 70' peut être située sous la membrane 14 en utilisant une partie du substrat. Pour cela, la section de l'ouverture d'arrivée de pression est réduite, ce qui permet d'avoir une partie du substrat en regard de la membrane. Cette exemple est représentée sur la figure 17A'.

Sur les figures 18A et 18B, on peut voir un exemple de réalisation particulièrement intéressant d'un capteur de pression comportant des moyens passifs de compensation de la pression statique.

Dans cet exemple de réalisation, un espace 72 est prévu entre la membrane et l'extrémité du bras de levier 14 afin de permettre une déformation de la membrane sans action sur le bras 14 dans une phase initiale de déformation de la membrane. L'espace 72 est déterminé en fonction de la proportion de pression statique à compenser. Par exemple, on peut souhaiter compenser 90% de cette pression statique, les jauges ne voient alors une contrainte qu'au-delà d'une pression appliquée au-dessus de 90% de la pression statique à compenser.

Grâce à cette réalisation, la résolution du capteur de pression peut être augmentée d'un facteur 5 à 10.

En variante, le capteur de pression peut comporter en plus de l'espace 72 une liaison mécanique souple entre la membrane et le bras d'amplification Cette liaison souple est dimensionnée pour ne transmettre quasiment aucune contrainte aux jauges tant que la membrane n'est pas en contact mécanique direct avec le bras d'amplification 14. Cette liaison mécanique souple permet que la membrane et le bras 14 soient au même potentiel électrique quelque soit la pression. La liaison souple est par exemple formée par une poutre souple ou un ressort.

Sur la figure 19, on peut voir un autre exemple de réalisation d'un capteur de pression comportant avantageusement une articulation souple 115 entre la membrane 4 et le bras 14. Cette articulation est, de type ressort ou poutre en flexion. Sur la figure 19, il s'agit d'une poutre en flexion 116 qui permet de transmettre entièrement l'effort le long de l'axe Z induit par la déformation de la membrane, tout en limitant l'effort parasite le long de l'axe X, i.e. suivant l'axe du bras 14 dû à cette déformation. Cette liaison présente une certaine souplesse suivant l'axe X de sorte à ne pas entraver la déformation de la membrane, et une certaine rigidité pour transmettre toute la déformation de la membrane au bras.

Les variantes de réalisation ont été décrites en considérant un capteur de pression à détection par jauge de contrainte, mais les variantes des figures 4, 5A, 5B, 6A, 6B, 7, 9, 10, 11, 12A, 12B, 13 à 19 s'appliquent à des capteurs de pression à détection capacitif ou à capteurs de pression résonants représentés sur les figures 2A, 2B, 3 et sur la figure 8 respectivement.

On peut envisager de mettre en oeuvre plusieurs bras de levier transmettant chacun la déformation à des moyens de détection distincts disposés autour de la membrane, les bras de levier s'étendant radialement.

En outre, les différentes variantes peuvent être combinées sans sortir du cadre de la présente invention.

Grâce à l'invention, on découple la membrane et les moyens de détection, ce qui permet de les optimiser séparément.

De plus, l'amplification de la contrainte dans le cas d'un capteur résonant ou à détection par jauge de contrainte et l'amplification du déplacement dans le cas d'un capteur à détection capacitif, apporte un gain en sensibilité important, le capteur de pression peut être rendu plus performant ou sa taille peut être réduite.

En outre, grâce à l'invention, la réalisation de capteurs de pression à mesure différentielle est technologiquement simplifiée, à la fois dans le cas de l'utilisation de moyens de détection piézorésistifs, que capacitifs ou résonants. Cette mesure différentielle permet d'augmenter le rapport signal/bruit et de limiter la sensibilité thermique du capteur.

De plus, la technologie de réalisation des capteurs de pression selon l'invention étant très proche des technologies de fabrication des capteurs inertiels MEMS et/ou NEMS en technologie de surface, il est possible de mutualiser une grande partie des procédés existants. Il est alors également possible de co-intégrer ces différents capteurs comme cela est représenté sur les figures 13 et 14.

Dans le cas particulier d'une détection par jauge de contrainte, la jauge peut être de section nanométrique, ce qui assure une concentration de contrainte plus importante et offre une sensibilité accrue. En outre, les jauges sont protégées du milieu extérieur par le capot. Dans le cas d'une détection capacitive, le volume de la cavité 10 n'intervient pas dans l'entrefer électrostatique entre la membrane et l'électrode fixe. On peut alors réaliser une cavité 10 présentant un large volume sous vide, ce qui permet d'obtenir un vide de référence susceptible d'être plus stable et plus poussé que dans les capteurs conventionnels.

En outre, l'entrefer électrostatique qui se situe entre la membrane et l'électrode fixe est bien contrôlé car il est défini par une couche sacrificielle.

La fermeture sous vide de la cavité est réalisée lors du scellement, par exemple eutectique, anodique, SDB (Silicon Direct Bonding), ou scellement direct. Dans ce cas le scellement utilise les forces de surface pour assurer l'adhésion des deux substrats..., ce type de fermeture permet d'obtenir une bonne qualité de vide, qui est plus fiable que celui obtenu au moyen d'un bouchage par dépôt.

Par ailleurs, le procédé de réalisation permet d'insérer un matériau getter dans la cavité sous vide 10, ce qui est particulièrement intéressant dans le cas où l'on souhaite avoir un vide de référence poussé et stable dans le temps, notamment pour réaliser un capteur sensible aux basses pressions.

Enfin, la reprise des contacts électriques de la membrane et du substrat peut être simplifiée, en utilisant une technologie de type TSV (Through Silicon Via) qui s'intègre au procédé de réalisation par technologie de surface de la partie sensible du capteur, et permettant une reprise des contacts soit par la face avant, soit par la face arrière du capteur.

Nous allons maintenant décrire un exemple de procédé de réalisation du capteur de pression à détection par jauges de contraintes des figures 1A et 1B, à l'aide des figures 15A à 15H, chaque figure représente l'élément en vue de dessus et en coupe.

Les emplacements de différentes parties du capteur de pression, en cours de réalisation dans les différentes étapes représentées, sont désignés par les références de ces parties.

Il s'agit d'un procédé de réalisation en technologie de surface i.e. par dépôt et usinage successifs de couches minces sur un substrat de base.

On part d'un substrat SOI 100 (Silicon on Insulator) qui peut être réalisé à partir d'un BOX ("Buried Oxyde") de 1 µm d'épaisseur et d'une couche de silicium actif 0,2 µm d'épaisseur. La deuxième couche peut être obtenue par épitaxie ou dépôt de silicium ou de SiGe.

Le couche supérieure de silicium 102 a une épaisseur comprise entre quelques dizaines de nm et quelques µm. La couche d'oxyde du substrat SOI est désignée 101.

On effectue une étape de lithographie afin de définir les jauges de contrainte, l'axe de torsion, le contour de la membrane 4 le contour des zones de contact et d'encastrement des jauges et de l'axe de torsion et l'ouverture de la reprise de contact en face arrière. Sur la figure 15A, des ouvertures au niveau des contacts des plots d'encastrement sont réalisés ce qui permet de faire remonter les contacts électriques entre le substrat 100 et la couche active 102 lors de l'étape d'épitaxie, suite à la gravure de l'oxyde dans ces ouvertures

On effectue ensuite une gravure de la couche de silicium avec arrêt sur la couche d'oxyde 101. La résine restante est éliminée.

On obtient l'élément représenté sur la figure 15A.

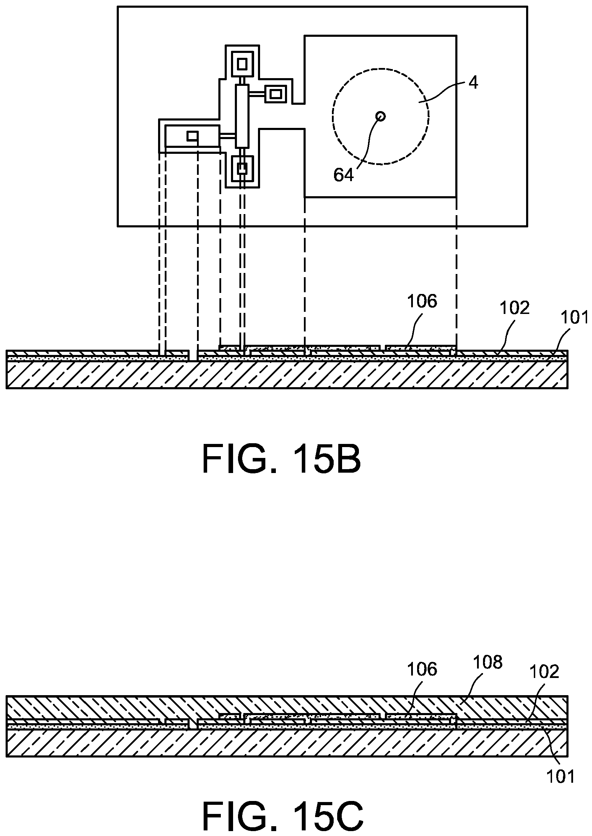

Lors d'une étape suivante, on effectue un dépôt d'une couche de SiO₂ 106. On effectue ensuite une lithographie pour protéger les jauges de contrainte, la membrane 4, et définir l'ouverture des zones de contact et des plots d'encastrement des jauges et de l'axe de torsion, et l'ouverture de la zone d'ancrage 64 du bras 14 sur la membrane 4. Une gravure d'oxyde des couches 101 et 106 a ensuite lieu avec arrêt sur le silicium de la couche 102 et sur le silicium du substrat SOI. La résine restante est éliminée. L'élément ainsi obtenu est visible sur la figure 15B.

Lors d'une étape suivante, a lieu un dépôt d'une couche 108 de silicium, monocristallin ou polycristallin, par exemple par épitaxie ayant typiquement une épaisseur comprise entre 1 µm et quelques dizaines de µm. Un polissage mécano-chimique de la couche 108 peut être réalisé. L'élément obtenu est visible sur la figure 15C.

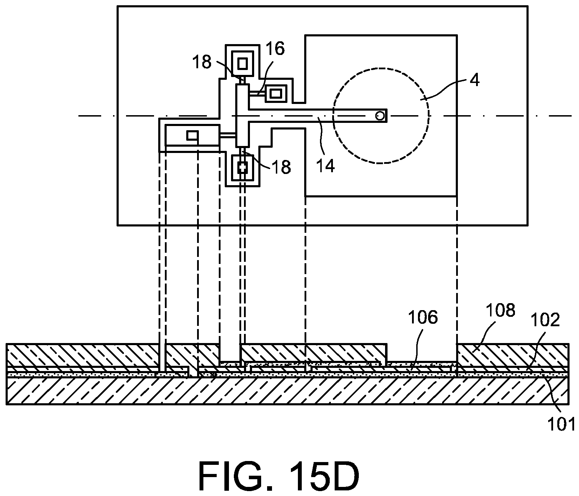

Lors d'une étape suivante, on effectue une lithographie sur la couche 108 afin de définir la zone d'ouverture de la membrane 4, et la zone d'ouverture des jauges 16, et de définir le bras 14 et les zones d'isolation des contacts. On effectue ensuite une gravure de la couche 108 avec arrêt sur la couche de SiO₂ 106 et 101. La résine restante est éliminée. L'élément obtenu est visible sur la figure 15D.

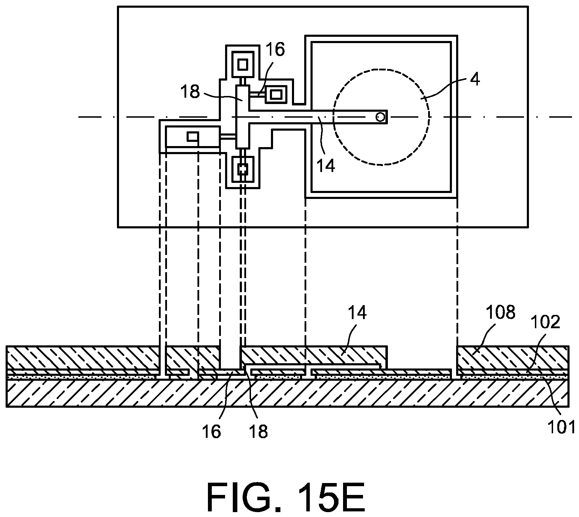

Lors d'une étape suivante, on libère le bras 14, l'axe de torsion et les jauges par gravure par exemple au moyen d'acide fluorhydrique vapeur. Lors de cette étape, la couche 106 est entièrement gravée ainsi qu'une partie de la couche de SiO₂ du substrat SOI. Lors de cette étape, la membrane 4 n'est pas encore libérée. L'élément obtenu est visible sur la figure 15E.

Lors d'une étape suivante, on effectue le scellement sous vide du capot au moyen d'un cordon 13. En variante, le scellement peut être par exemple de type eutectique, SDB ou anodique dans le cas d'un capot en verre, i.e. sans cordon, le scellement étant obtenu par adhésion directe des deux surfaces 12 et 108. On réalise préalablement une cavité dans le capot avant scellement, au moins au-dessus des parties mobiles.

Le capot peut avoir été préalablement préparé. La préparation du capot peut comporter les étapes de réalisation d'une cavité, du dépôt de getter, de réalisation de routages électriques voire d'une électronique (co-integration CMOS) dans le cas d'un scellement eutectique,...

La cavité étanche 10 autour de la membrane est alors formée.

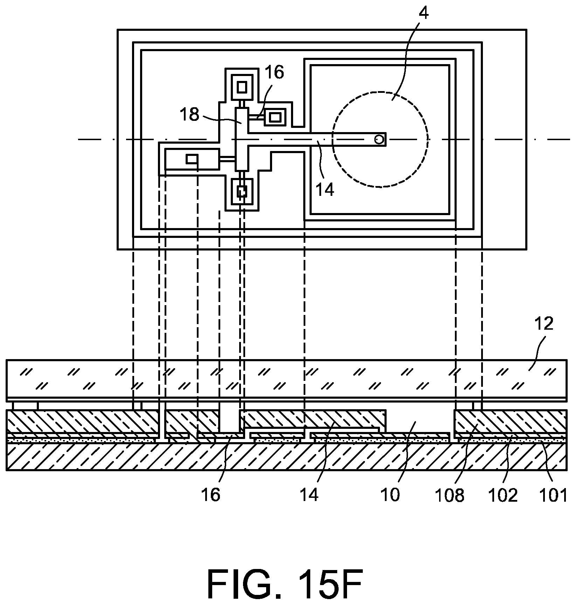

On réalise ensuite un amincissement du substrat par exemple par abrasion en face arrière ou "back-grinding" et polissage mécano-chimique. L'élément obtenu est visible sur la figure 15F.

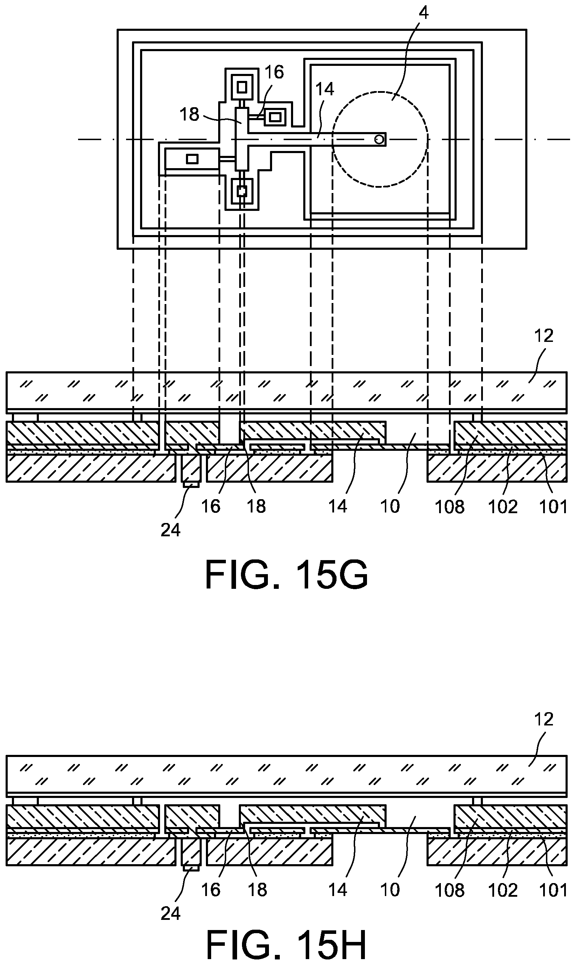

Lors d'une étape suivante, on effectue un dépôt d'une couche métallique sur la face arrière du substrat afin de réaliser le contact en face arrière. Ensuite, une lithographie est effectuée sur cette couche pour délimiter le contact en face arrière et enfin une gravure de la couche métallique est réalisée. La résine sur la couche métallique restante est éliminée. Une nouvelle lithographie est réalisée en face arrière pour délimiter la zone d'isolation des contacts et l'ouverture de la membrane 4, ainsi qu'une gravure du substrat en face arrière, par exemple par gravure profonde par ions réactifs ou DRIE ("deep reactive-ion etching" en anglais) avec un arrêt sur la couche d'oxyde 101 du substrat SOI. La résine restante est éliminée. L'élément obtenu est visible sur la figure 15G.

Enfin, on effectue une gravure en face arrière de la couche d'oxyde du substrat SOI. La membrane est libérée. L'usinage du capteur inertiel est fait en même temps que la gravure de la partie MEMS (figure 15D) en s'arrêtant sur la couche 101 et la libération du capteur inertiel se fait durant l'étape 15E.L'élément obtenu est visible sur la figure 15H.

En variante, il est envisageable d'utiliser à la place d'un substrat SOI un substrat standard, sur lequel un dépôt d'une couche sacrificielle, par exemple d'oxyde, a été effectué, ainsi qu'un dépôt d'une première couche de polysilicium ou de SiGe-Poly. Les étapes suivantes sont similaires à celles décrites en partant d'un substrat SOI.

Les valeurs des épaisseurs sont données uniquement à titre d'exemple. D'une manière générale, les couches sacrificielles (en oxyde) sont comprises entre quelques dizaines de nm et quelques microns, et les couches actives, comme le Si, SiGe, ... sont comprises entre quelques dizaines de nm et quelques dizaines de µm.

Le dispositif de mesure de pression selon l'invention peut être utilisé dans tous les domaines où une mesures de pression est requise, par exemple dans le domaine automobile, médicale, dans l'avionique, et également pour des applications grand public. En outre, ce capteur peut être utilisé pour réaliser un microphone pour des applications grand public, comme par exemple dans des téléphones portables, ou le domaine médical pour réaliser des prothèses auditives, ....

## Revendications

1. Dispositif de mesure de pression MEMS et/ou NEMS comportant au moins une membrane (4, 4') déformable suspendue sur un substrat (2), une des faces de la membrane étant destinée à être soumise à la pression à mesurer, des moyens de détection (6, 6', 6") de la déformation de la membrane (4, 4'), **caractérisé en ce que** lesdits moyens de détection (6, 6', 6") sont disposés au moins partiellement sur le substrat (2) et des moyens de transmission (14) de la déformation de la membrane (4, 4'), aux moyens de détection (6, 6', 6"), lesdits moyens de transmission étant indéformables, lesdits moyens de transmission étant suspendus au-dessus de la membrane, lesdits moyens de transmission (14) étant articulés en rotation sur le substrat (2) autour d'un axe (Y) sensiblement parallèle au plan de la membrane (4, 4') et étant disposés en regard d'une face de la membrane opposée à la face destinée à être soumise à la pression à mesurer de telle sorte qu'au moins au-delà d'une pression donnée, lesdits moyens de transmission et la membrane soient solidaires en déplacement et de sorte que les moyens de transmission transmettent aux moyens de détection (6, 6', 6"), de manière amplifiée, la déformation ou la contrainte issue de la déformation de la membrane (4, 4').

2. Dispositif de mesure de pression selon la revendication 1, dans lequel les moyens de transmission (14) et la membrane (4, 4') sont solidaires en mouvement au moins au-delà de la pression donnée, dans une zone de déformation maximale de la membrane.

3. Dispositif de mesure de pression selon la revendication 1 ou 2, dans lequel les moyens de transmission (14) comportent au moins un bras longitudinal comportant au moins une première extrémité (14.1) au niveau de laquelle se situent les moyens de détection (6, 6', 6") et une deuxième extrémité (14.2) au niveau de laquelle le bras (14) est solidaire en déplacement de la membrane (4, 4') au moins au-delà de la pression donnée.

4. Dispositif de mesure de pression selon la revendication 3, dans lequel la deuxième extrémité du bras est solidaire mécaniquement de la membrane quelle que soit la valeur de la pression.

5. Dispositif de mesure de pression selon la revendication 3, dans lequel un espace est prévu entre la deuxième extrémité (14.2) du bras (14) et la membrane pour une pression inférieure à la pression donnée.

6. Dispositif de mesure de pression selon la revendication 5, dans lequel le bras (14) est relié électriquement à la membrane.

7. Dispositif de mesure de pression selon la revendication 5 ou 6, dans lequel la pression donnée est inférieure ou égale à la pression minimale à mesurer.

8. Dispositif de mesure de pression selon la revendication 4, dans lequel le bras longitudinal (14) est solidaire de la membrane (4, 4') par l'intermédiaire d'une liaison souple suivant l'axe longitudinal (X) du bras et rigide suivant un axe (Z) de déformation de la membrane.

9. Dispositif de mesure de pression selon l'une des revendications 3 à 8, dans lequel les moyens de transmission comportent moins une poutre de torsion (18) reliant la première extrémité du bras longitudinal aux moyens de détection, orthogonale au bras longitudinal (14), l'axe de rotation (Y) étant formé par ladite poutre de torsion qui est ancrée d'une part à la première extrémité du bras et d'autre part au substrat et aux moyens de détection.

10. Dispositif de mesure de pression selon l'une des revendications 3 à 8, dans lequel les moyens de transmission comportent en outre au moins une poutre de flexion (118), sensiblement parallèle au bras longitudinal, l'axe de rotation (Y) étant formé par ladite poutre de flexion (118) qui est ancrée d'une part au bras longitudinal (14) et d'autre part au substrat.

11. Dispositif de mesure de pression selon la revendication 10, dans lequel le bras longitudinal présente un motif en « U », ce motif comportant deux extrémités correspondant auxdites premières extrémités, ces dernières étant reliées respectivement aux moyens de détection par l'intermédiaires de poutres d'extension latérales.

12. Dispositif de mesure de pression selon l'une des revendications 1 à 11, comportant des moyens (41) pour rigidifier la membrane (4'), par exemple formés par des zones de surépaisseur sur la membrane (4'), par exemple disposées radialement ou en nid d'abeille.

13. Dispositif de mesure de pression selon l'une des revendications 1 à 12 en combinaison avec la revendication 3, comportant un contrepoids (42) fixé sur le bras (14) au niveau de la première extrémité (14.1) du bras (14).

14. Dispositif de mesure de pression selon l'une des revendications 1 à 13, comportant plusieurs membranes (4) déformables soumises à la même pression, les moyens de transmission (14) et toutes les membranes étant solidaires en mouvement au moins au-delà de la pression donnée.

15. Dispositif de mesure de pression selon l'une des revendications 1 à 14, comportant une butée (38) disposée en regard de la membrane (4) à l'opposé de la face de la membrane soumise à la pression de sorte à limiter sa déformation.

16. Dispositif de mesure de pression selon l'une des revendications 1 à 15, comportant un capot (12) sur le substrat (2) et définissant une cavité (10) autour de la membrane (4, 4') à l'opposé de la face soumise à la pression à mesurer.

17. Dispositif de mesure de pression selon l'une des revendications 1 à 16 en combinaison avec la revendication 9, dans lequel les moyens de détection (6) comportent au moins une jauge de contrainte suspendue reliée par une extrémité au substrat par un plot d'ancrage et par une autre extrémité à la poutre de torsion (18) ou au bras de transmission.

18. Dispositif de mesure de pression selon la revendication précédente en combinaison avec les revendications 9 et 17, dans lequel les moyens de détection (6") comportent au moins un résonateur (44) relié par une première extrémité à la poutre de torsion (18) et par une autre extrémité à un plot d'ancrage sur le substrat, des moyens d'excitation (48) du résonateur et des moyens de détection (50) de la fréquence de résonance du résonateur ou deux jauges de contrainte (16) fixées par une extrémité sur la poutre de torsion (18) de part et d'autre de celle-ci et par une autre extrémité au substrat par des plots d'ancrage.

19. Dispositif de mesure de pression selon l'une des revendications 1 à 18, comportant des moyens actifs de compensation de la pression statique.

20. Dispositif de mesure de pression selon la revendication 19, dans lequel les moyens actifs de compensation de la pression statique comportent une paire d'électrodes (66.1), l'une d'entre elles étant solidaire des moyens de transmission (14), ladite paire (66.1) étant située du côté de la membrane (4) par rapport à l'axe de rotation des moyens de transmission leur articulation en rotation sur le substrat.

21. Dispositif de mesure de pression selon la revendication 19, dans lequel les moyens actifs de compensation de la pression statique comportent une électrode (66.1) formée au-dessous de la membrane sur le substrat.

22. Dispositif de mesure de pression selon l'une des revendications 1 à 21, comportant des moyens pour effectuer des autotests et/ou une auto-calibration.

23. Dispositif de mesure de pression selon la revendication 22, dans lequel les moyens pour effectuer des autotests et/ou une auto-calibration comportent au moins une électrode (66.2, 66.1) solidaire des moyens de transmission (14) à l'opposée de la membrane par rapport à l'articulation des moyens de transmission (14) sur le substrat.

24. Dispositif de mesure de pression selon l'une des revendications 1 à 23 en combinaison avec la revendication 16, dans lequel la cavité (10) est étanche pour former un capteur de pression absolue ou est connectée à l'environnement extérieur pour former un capteur de pression relative ou un microphone.

25. Ensemble MEMS et/ou NEMS comportant au moins un dispositif de mesure de pression selon l'une des revendications 1 à 24 et au moins un capteur inertiel réalisé sur et dans le même substrat.

## Patentansprüche

1. MEMS- und/oder NEMS-Druckmessvorrichtung umfassend wenigstens eine verformbare Membran (4, 4'), die an einem Substrat (2) aufgehängt ist, wobei eine der Flächen der Membran dazu ausgelegt ist, dem zu messenden Druck ausgesetzt zu sein, sowie Mittel (6, 6', 6") zur Erfassung der Verformung der Membran (4, 4'), **dadurch gekennzeichnet, dass** die Erfassungsmittel (6, 6', 6") wenigstens teilweise auf dem Substrat (2) angeordnet sind, sowie Mittel (14) zur Übertragung der Verformung der Membran (4, 4') zu den Erfassungsmitteln (6, 6', 6"), wobei die Übertragungsmittel nicht verformbar sind, wobei die Übertragungsmittel über der Membran aufgehängt sind, wobei die Übertragungsmittel (14) an dem Substrat (2) um eine Achse (Y), die im Wesentlichen parallel zur Ebene der Membran (4, 4') ist, drehbar angelenkt sind und gegenüber einer Fläche der Membran angeordnet sind, die entgegengesetzt ist zu der Fläche, die dazu ausgelegt ist, dem zu messenden Druck ausgesetzt zu sein, derart, dass wenigstens jenseits eines gegebenen Drucks die Übertragungsmittel und die Membran verlagerungsverbunden sind, und derart, dass die Übertragungsmittel die Verformung oder die aus der Verformung der Membran (4, 4') resultierende Spannung in verstärkter Weise zu den Erfassungsmitteln (6, 6', 6") übertragen.

2. Druckmessvorrichtung nach Anspruch 1, wobei die Übertragungsmittel (14) und die Membran (4, 4') wenigstens jenseits des gegebenen Drucks in einer Zone maximaler Verformung der Membran bewegungsverbunden sind.

3. Druckmessvorrichtung nach Anspruch 1 oder 2, wobei die Übertragungsmittel (14) wenigstens einen longitudinalen Arm umfassen, umfassend wenigstens ein erstes Ende (14.1), in dessen Bereich sich die Erfassungsmittel (6, 6', 6") befinden, und ein zweites Ende (14.2), in dessen Bereich der Arm (14) wenigstens jenseits des gegebenen Drucks mit der Membran (4, 4') bewegungsverbunden ist.

4. Druckmessvorrichtung nach Anspruch 3, wobei das zweite Ende des Arms unabhängig vom Wert des Drucks mechanisch mit der Membran verbunden ist.

5. Druckmessvorrichtung nach Anspruch 3, wobei ein Raum vorgesehen ist zwischen dem zweiten Ende (14.2) des Arms (14) und der Membran für einen Druck kleiner als der gegebene Druck.

6. Druckmessvorrichtung nach Anspruch 5, wobei der Arm (14) elektrisch mit der Membran verbunden ist.

7. Druckmessvorrichtung nach Anspruch 5 oder 6, wobei der gegebene Druck kleiner oder gleich dem minimalen zu messenden Druck ist.

8. Druckmessvorrichtung nach Anspruch 4, wobei der longitudinale Arm (14) mit der Membran (4, 4') mittels einer Verbindung verbunden ist, die entlang der longitudinalen Achse (X) des Arms flexibel und entlang einer Verformungsachse (Z) der Membran starr ist.

9. Druckmessvorrichtung nach einem der Ansprüche 3 bis 8, wobei die Übertragungsmittel wenigstens einen Torsionsbalken (18) umfassen, der das erste Ende des longitudinalen Arms mit den Erfassungsmitteln orthogonal zum longitudinalen Arm (14) verbindet, wobei die Drehachse (Y) durch den Torsionsbalken gebildet ist, der einerseits am ersten Ende des Arms und andererseits am Substrat und an den Erfassungsmitteln verankert ist.

10. Druckmessvorrichtung nach einem der Ansprüche 3 bis 8, wobei die Übertragungsmittel ferner wenigstens einen Flexionsbalken (118) im Wesentlichen parallel zum longitudinalen Arm umfassen, wobei die Drehachse (Y) durch den Flexionsbalken (118) gebildet ist, der einerseits am longitudinalen Arm (14) und andererseits am Substrat verankert ist.

11. Druckmessvorrichtung nach Anspruch 10, wobei der longitudinale Arm ein "U"-Motiv aufweist, wobei dieses Motiv zwei Enden umfasst, die den ersten Enden entsprechen, wobei letztgenannte jeweils mit den Erfassungsmitteln mittels lateralen Verlängerungsbalken verbunden sind.

12. Druckmessvorrichtung nach einem der Ansprüche 1 bis 11, umfassend Mittel (41) zum Versteifen der Membran (4'), die beispielsweise durch Zusatzdickenzonen auf der Membran (4') gebildet sind, die beispielsweise radial oder in einem Wabenmuster angeordnet sind.

13. Druckmessvorrichtung nach einem der Ansprüche 1 bis 12 in Kombination mit Anspruch 3, umfassend ein Gegengewicht (42), das an dem Arm (14) im Bereich des ersten Endes (14.1) des Arms (14) befestigt ist.

14. Druckmessvorrichtung nach einem der Ansprüche 1 bis 13, umfassend mehrere verformbare Membrane (4), die dem gleichen Druck ausgesetzt sind, wobei die Übertragungsmittel (14) und alle Membrane wenigstens jenseits des gegebenen Drucks bewegungsverbunden sind.

15. Druckmessvorrichtung nach einem der Ansprüche 1 bis 14, umfassend einen Anschlag (38), der gegenüber der Membran (4) entgegengesetzt zur Fläche der Membran angeordnet ist, die dem Druck ausgesetzt ist, um ihre Verformung zu begrenzen.

16. Druckmessvorrichtung nach einem der Ansprüche 1 bis 15, umfassend einen Deckel (12) auf dem Substrat (2), der einen Hohlraum (10) um die Membran (4, 4') herum entgegengesetzt zu der Fläche definiert, die dem zu messenden Druck ausgesetzt ist.

17. Druckmessvorrichtung nach einem der Ansprüche 1 bis 16 in Kombination mit Anspruch 9, wobei die Erfassungsmittel (6) wenigstens einen Aufhängungsspannungsmesser umfassen, der an einem Ende mit dem Substrat durch einen Verankerungspunkt verbunden ist und an einem anderen Ende mit dem Torsionsbalken (18) oder mit dem Übertragungsarm.

18. Druckmessvorrichtung nach dem vorhergehenden Anspruch in Kombination mit den Ansprüchen 9 und 17, wobei die Erfassungsmittel (6") wenigstens einen Resonator (44) umfassen, der an einem ersten Ende mit dem Torsionsbalken (18) verbunden ist und an einem anderen Ende mit einem Verankerungspunkt an dem Substrat, sowie Mittel (48) zur Anregung des Resonators und Mittel (50) zur Erfassung der Resonanzfrequenz des Resonators oder zwei Spannungsmessgeräte (16), die mit einem Ende an dem Torsionsbalken (18) auf beiden Seiten desselben befestigt sind, und mit einem anderen Ende an dem Substrat durch Verankerungspunkte.

19. Druckmessvorrichtung nach einem der Ansprüche 1 bis 18, umfassend aktive Mittel zur Kompensation des statischen Drucks.

20. Druckmessvorrichtung nach Anspruch 19, wobei die aktiven Mittel zur Kompensation des statischen Drucks ein Paar von Elektroden (66.1) umfassen, von denen eine mit den Übertragungsmitteln (14) verbunden ist, wobei das Paar (66.1) an der Seite der Membran (4) bezüglich der Drehachse der Übertragungsmittel zur Drehanlenkung an dem Substrat angeordnet ist.

21. Druckmessvorrichtung nach Anspruch 19, wobei die aktiven Mittel zur Kompensation des statischen Drucks eine Elektrode (66.1) umfassen, die unter der Membran an dem Substrat gebildet ist.

22. Druckmessvorrichtung nach einem der Ansprüche 1 bis 21, umfassend Mittel zur Durchführung von Selbsttests und/oder einer Autokalibration.

23. Druckmessvorrichtung nach Anspruch 22, wobei die Mittel zur Durchführung der Selbsttests und/oder einer Autokalibration wenigstens eine Elektrode (66.2, 66.1) umfassen, die verbunden ist mit den Übertragungsmitteln (14) entgegengesetzt zur Membran bezüglich der Anlenkung der Übertragungsmittel (14) an dem Substrat.

24. Druckmessvorrichtung nach einem der Ansprüche 1 bis 23 in Kombination mit Anspruch 16, wobei der Hohlraum (10) dicht ist, um einen Absolutdrucksensor zu bilden, oder mit der Außenumgebung verbunden ist, um einen Relativdrucksensor oder ein Mikrophon zu bilden.

25. MEMS- und/oder NEMS-Anordnung, umfassend wenigstens eine Druckmessvorrichtung nach einem der Ansprüche 1 bis 24 und wenigstens einen Trägheitssensor, der auf und in dem gleichen Substrat realisiert ist.

## Claims

1. A MEMS and/or NEMS pressure measurement device comprising at least one deformable membrane (4, 4') suspended on a substrate (2), one of the faces of the membrane being intended to be subjected to the pressure to be measured, means (6, 6', 6") for detecting the deformation of the membrane (4, 4'), **characterized in that** said detection means (6, 6', 6") are provided at least partly on the substrate (2) and means (14) for transmitting the deformation of the membrane (4, 4'), to the detection means (6, 6', 6"), said transmission means being non-deformable, said transmission means being suspended above the membrane (4), said transmission means (14) being rotatably hinged to the substrate (2) about an axis (Y) substantially parallel to the plane of the membrane (4, 4') and being provided facing a face of the membrane opposite to the face intended to be subjected to the pressure to be measured so that at least beyond a given pressure, said transmission means and the membrane are movably integral with each other and such that the transmission means transmit to the detection means (6, 6', 6"), in an amplified manner, the deformation or the stress from the deformation of the membrane (4, 4').

2. The pressure measurement device according to claim 1, wherein the transmission means (14) and the membrane (4, 4') are movably integral with each other at least beyond the given pressure, in a maximum deformation area of the membrane.

3. The pressure measurement device according to claim 1 or 2, wherein the transmission means (14) comprise at least one longitudinal arm comprising at least one first end (14.1) at which the detection means (6, 6', 6") are located and a second end (14.2) at which the arm (14) is movably integral with the membrane (4, 4') at least beyond the given pressure.

4. The pressure measurement device according to claim 3, wherein the second end of the arm is mechanically integral with the membrane regardless of the pressure value.

5. The pressure measurement device according to claim 3, wherein a spacing is provided between the second end (14.2) of the arm (14) and the membrane for a pressure lower than the given pressure.

6. The pressure measurement device according to claim 5, wherein the arm (14) is electrically connected to the membrane.

7. The pressure measurement device according to claim 5 or 6, wherein the given pressure is equal or less than the pressure to be measured.

8. The pressure measurement device according to claim 4, wherein the longitudinal arm (14) is integral with the membrane (4, 4') through a connection being flexible along the longitudinal axis (X) of the arm and rigid along an axis (Z) of deformation of the membrane.

9. The pressure measurement device according to one of claims 3 to 8, wherein the transmission means comprise at least one torsion beam (18) connecting the first end of the longitudinal arm to the detection means, which is orthogonal to the longitudinal arm (14), the rotation axis (Y) being formed by said torsion beam which is secured on the one hand to the first end of the arm and on the other hand to the substrate and to the detection means.

10. The pressure measurement device according to one of claims 3 to 8, wherein the transmission means further comprise at least one flexure beam (118), substantially parallel to the longitudinal arm, the rotation axis (Y) being formed by said flexure beam (118) which is secured on the one hand to the longitudinal arm (14) and on the other hand to the substrate.

11. The pressure measurement device according to claim 10, wherein the longitudinal arm has a "U" pattern, this pattern comprising two ends corresponding to said first ends, the latter being respectively connected to the detection means through side extension beams.

12. The pressure measurement device according to one of claims 1 to 11, comprising means (41) for rigidifying the membrane (4'), for example formed by extra-thickness areas on the membrane (4'), for example provided radially or as a honeycomb.

13. The pressure measurement device according to one of claims 1 to 12 in combination of claim 3, comprising a counterweight (42) fixed to the arm (14) at the first end (14.1) of the arm (14).

14. The pressure measurement device according to one of claims 1 to 13, comprising several deformable membranes (4) subjected to the same pressure, the transmission means (14) and all the membranes being movably integral with each other at least beyond the given pressure.

15. The pressure measurement device according to one of claims 1 to 14, comprising a stop (38) provided facing the membrane (4) opposite the face of the membrane which is subjected to the pressure so as to restrict the deformation thereof.

16. The pressure measurement device according to one of claims 1 to 15, comprising a cap (12) on the substrate (2) and defining a cavity (10) about the membrane (4, 4') opposite the face subjected to the pressure to be measured.

17. The pressure measurement device according to one of claims 1 to 16 in combination with claim 9, wherein the detection means (6) comprise at least one suspended strain gauge connected by one end to the substrate through an anchor pad and by another end to the torsion beam (18) or to the transmission arm.

18. The pressure measurement device according to the previous claim in combination with claims 9 and 17, wherein the detection means (6) comprise at least one suspended strain gauge connected by one end to the substrate through a anchor pad and by another end to the torsion beam (18) or to the transmission arm and wherein the detection means (6) comprise two strain gauges (16) attached by one end to the torsion beam (18) on either side thereof and by another end to the substrate through anchor pads.

19. The pressure measurement device according to one of claims 1 to 18, comprising active means for compensating static pressure

20. The pressure measurement device according to claim 19, wherein the active means for compensating static pressure comprise a pair of electrodes (66.1), one of the electrodes being integral with the transmission means, said pair of electrodes (66.1) being located on the side of the membrane with respect to the axis of rotation of the transmission means (14) their articulation in rotation on the substrate.

21. The pressure measurement device according to claim 19, wherein the means for compensating the active static pressure comprise an electrode (66.1) formed below the membrane on the substrate.

22. The pressure measurement device according to one of claims 1 to 21, comprising means for performing self-tests and/or a self-calibration.

23. The pressure measurement device according to claim 22, wherein the means for performing self-tests and/or a self-calibration comprise a least one electrode (66.1, 66.2) secured to the transmission means, said electrode being opposite the membrane with respect to the axis of rotation of the transmission means (14) on the substrate.

24. The pressure measurement device according to one of claims 1 to 23 in combination with claim 16, wherein the cavity is a tight cavity to form an absolute pressure sensor or the cavity is connected to the external environment to form a relative pressure sensor or a microphone.

25. MEMS and/or NEMS assembly comprising at least one pressure measurement device according to one of claims 1 to 24 and at least one inertial sensor made on and in the same substrate.
